(19) Europäisches Patentamt
European Patent Office
Office européen des brevets

(11) **EP 4 597 539 A1**

(12) **EUROPEAN PATENT APPLICATION**

(43) Date of publication:
06.08.2025 Bulletin 2025/32

(21) Application number: 24154738.9

(22) Date of filing: 30.01.2024

(51) International Patent Classification (IPC):
*H01J 37/12* *(2006.01)*

(52) Cooperative Patent Classification (CPC):
**H01J 37/12;** H01J 2237/024; H01J 2237/1205;
H01J 2237/2817

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **TOONEN, Wiebe, Floris**
  **5500 AH Veldhoven (NL)**
• **KRECINIC, Faruk**
  **5500 AH Veldhoven (NL)**
• **SCACCABAROZZI, Luigi**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **CHARGED PARTICLE-OPTICAL ARRANGEMENT FOR A CHARGED PARTICLE BEAM APPARATUS**

(57) A charged particle-optical arrangement for a charged particle beam apparatus configured to operate on at least one beam of charged particles, the electron-optical arrangement comprising: a first plate which defines at least one first aperture for passage of the at least one beam therethrough; and a second plate which defines at least one second aperture for passage of the at least one beam therethrough; and an actuator arrangement configured to apply a force to the first plate.

## Fig. 11

EP 4 597 539 A1

## Description

FIELD

The embodiments provided herein generally relate to apparatus for directing charged particles such as electrons towards a sample and related apparatus and methods.

BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems with a charged particle beam have been used to assess objects, such as a pattern inspection systems used, for example, to detect pattern defects. These tools typically use electron microscopy techniques, such as a scanning electron microscope (SEM). In an embodiment of SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incident charged particles. As an area of the sample is inspected, the signals comprise data which is processed to generate the inspection image corresponding to the inspected area of the sample.

Some pattern assessment systems may be configured to operate on a plurality of beams of electrons to form a plurality of probing spots on the target. The beams of electrons can be controlled by applying potentials to electrodes in charged particle-optical elements. The potentials define electric fields that can be used to influence trajectories of charged particles in a desired manner, for example to deflect or focus beams of the charged particles. When a potential difference is applied between two adjacent electrodes, the resulting electric field causes a force, such as an attractive force, to be exerted on each electrode in the direction of the other electrode. This can cause the electrodes to become deformed and, for example, to take a bowed form. The deformation of the electrodes can lead to field curvature which results in focus errors at the target surface.

SUMMARY

It is an object of the present disclosure to at least partially address the problem of focus errors caused by the deformation of electrodes in charged particle beam apparatuses.

According to an aspect of the invention, there is provided a charged particle-optical arrangement for a charged particle beam apparatus configured to operate on at least one beam of charged particles, the electron-optical arrangement comprising: a first plate which defines at least one first aperture for passage of the at least one beam therethrough; and a second plate which defines at least one second aperture for passage of the at least one beam therethrough; and an actuator arrangement configured to apply a force to the first plate.

According to an aspect of the invention, there is provided a method of operating a charged particle-optical arrangement of an charged particle beam apparatus for directing one or more charged particle beams towards a sample, the method comprising: applying a potential difference between a first plate and a second plate so as to apply a deforming force between the first and second plates, wherein the first plate defines at least one first aperture for passage of at least one beam therethrough and the second plate defines at least one second aperture for passage of the at least one beam therethrough; and controlling an actuator arrangement to apply an actuating force to the first plate which counteracts the deforming force applied to the first plate.

Advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

**FIG. 1** is a schematic diagram illustrating an exemplary assessment apparatus.

**FIG. 2** is a schematic diagram illustrating an exemplary multibeam charged particle-optical device that is part of the exemplary assessment apparatus of **FIG. 1.**

**FIG. 3** is a schematic diagram of an exemplary charged particle-optical device comprising a collimator element array and a scan-deflector array that is part of the exemplary assessment apparatus of **FIG. 1.**

**FIG. 4** is a schematic diagram of an exemplary charged particle-optical device array comprising the charged particle-optical devices of **FIG. 3.**

**FIG. 5** is a schematic diagram of an alternative exemplary charged particle-optical device that is part of the exemplary assessment apparatus of **FIG. 1.**

**FIG. 6** is a schematic cross-sectional view of a portion of an objective lens array of an exemplary arrangement.

**FIG. 7** is bottom view of the portion of the objective lens array of **FIG. 6.**

**FIG. 8** is an enlarged schematic cross-sectional view of a detector which may be incorporated in the objective lens of **FIG. 6.**

**FIG. 9** is a schematic cross-sectional view of an electron-optical arrangement illustrating electrostatically-induced deformation (bow).

**FIG. 10** is a schematic side sectional view showing equipotential lines in a region near an aperture of an electrode of an electrostatic lens during operation, to illustrate operation of the electrostatic lens.

**FIG. 11** is a schematic cross-sectional view of an electron-optical arrangement comprising an actuator arrangement.

**FIG. 12** is a schematic cross-sectional view of an electron-optical arrangement comprising an actuator arrangement.

**FIG. 13** is a schematic cross-sectional view of an electron-optical arrangement comprising an actuator arrangement.

**FIG. 14A** is a schematic plan view of an electrode of an electron-optical arrangement comprising an actuator arrangement.

**FIG. 14B** is a schematic plan view of an electrode of an electron-optical arrangement comprising an actuator arrangement.

**FIG. 14C** is a schematic plan view of an electrode of an electron-optical arrangement comprising an actuator arrangement.

**FIG. 15** is a schematic cross-sectional view of a module comprising the electron-optical arrangement depicted in **FIG. 11.**

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. The single beam may be referred to as a primary beam. For higher throughput such as for assessment, some designs of apparatus use multiple focused beams of charged particles (e.g. electrons), i.e. a multibeam of primary beams. The multibeam of primary beams may be arranged in a beam grid. The component beams of the multibeam may be referred to as beams, sub-beams or beamlets. The primary beams in the beam grid (or a multibeam) may scan different parts of a target simultaneously. Beams in a beam grid may have a determined relative position to each other within the beam grid. The position of the beams within the beam grid may correspond to a pattern such as a regular pattern such as two-dimensional grid of a repeating pattern having a tessellating shape, such as a rectangular grid (e.g. a square grid) or a hexagonal grid. Note reference to a beam grid herein is intended also to refer to a multibeam in which the beams may be arranged in a non-regular pattern. A multibeam assessment apparatus may therefore assess a target much quicker, e.g. by moving the target at a higher speed, than a single-beam assessment apparatus.

An implementation of a known multibeam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

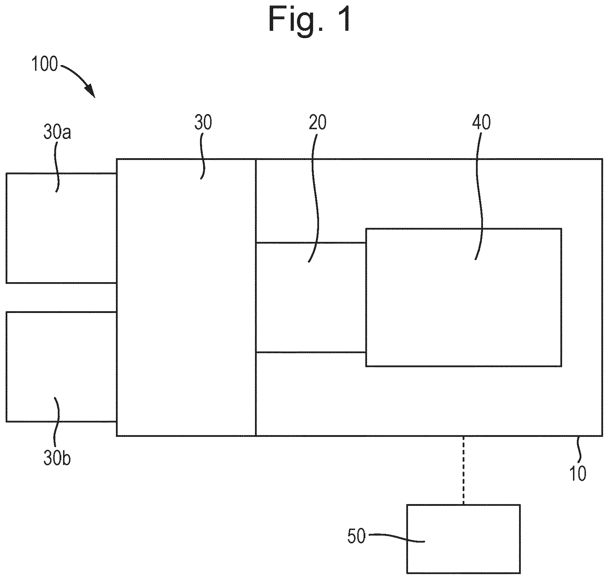

Reference is now made to **FIG. 1,** which is a schematic diagram illustrating an exemplary assessment apparatus 100, or inspection apparatus. The assessment apparatus 100 of **FIG. 1** includes a vacuum chamber 10, a load lock chamber 20, a charged particle-optical apparatus, an equipment front end module (EFEM) 30 and a controller 50. The charged particle-optical apparatus may be within the vacuum chamber 10. The charged particle-optical apparatus may comprise a charged particle-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. A charged particle-optical apparatus may comprise either a single beam or a multibeam charged particle-optical device.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of a main chamber 10 housing an electron beam assessment apparatus, it should be noted that aspects of the disclosure in their broadest sense are not limited to a chamber housing a charged particle-optical device. Rather, it is appreciated that the foregoing principles may also be applied to other apparatuses and other arrangements of apparatus that operate under the second pressure.

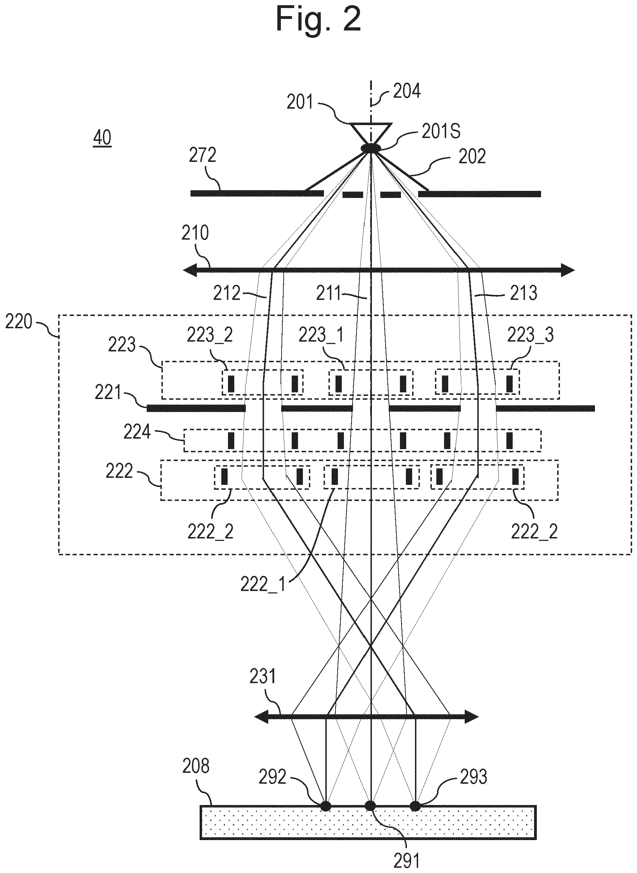

Reference is now made to **FIG. 2,** which is a schematic diagram of an exemplary multibeam charged particle-optical device 40 and a stage of an assessment apparatus, e.g. the assessment apparatus 100 of **FIG. 1.** The exemplary multibeam charged particle-optical device 40 depicted in **FIG. 2** is an example of the charged particle-optical device 40 of the assessment apparatus 100 of **FIG. 1.** In an alternative embodiment, the assessment apparatus 100 is a single-beam assessment apparatus. The charged particle-optical device 40 may comprise an electron source 201, a beam former array 272 (also known as a gun aperture plate, a coulomb aperture array or a pre-sub-beamforming aperture array), a condenser lens 210, a source converter (or micro-optical array) 220, an objective lens 231, and a target 208 (for example a sample). In an embodiment the condenser lens 210 is magnetic. The target 208 may be supported by a support on the stage. The stage may be motorized. The stage moves so that the target 208 is scanned by the incident electrons. The electron source 201, the beam former array 272, the condenser lens 210 may be the components of an illumination apparatus comprised by the charged particle-optical device 40. The source converter 220 (also known as a source conversion unit), described in more detail below, and the objective lens 231 may be the components of a projection apparatus comprised by the charged particle-optical device 40.

The electron source 201, the beam former array 272, the condenser lens 210, the source converter 220, and the objective lens 231 may be described as being are aligned with a primary electron-optical axis 204 of the charged particle-optical device 40. The electron source 201 may generate a primary beam 202 generally along the electron-optical axis 204 and with a source crossover (virtual or real) 201s. During operation, the electron source 201 is configured to emit electrons. The electrons are extracted or accelerated by an extractor and/or an anode to form the primary beam 202.

The beam former array 272 cuts the peripheral electrons of primary electron beam 202 to reduce a consequential Coulomb effect. The primary-electron beam 202 may be trimmed into a specified number of sub-beams, such as three sub-beams 211, 212 and 213, by the beam former array 272. It should be understood that the description is intended to apply to a charged particle-optical device 40 with any number of sub-beams such as one, two or more than three for example twenty five, one hundred, or even around three hundred. The beam former array 272, in operation, is configured to block off peripheral electrons to reduce the Coulomb effect.

The source converter 220 is configured to convert the beam (including sub-beams if present) transmitted by the beam former array 272 into the sub-beams that are projected towards the target 208. In an embodiment the source converter is a unit. Alternatively, the term source converter may be used simply as a collective term for the group of components that form the beamlets from the sub-beams.

As shown in **FIG. 2,** in an embodiment the charged particle-optical device 40 comprises a beam-limiting aperture array 221 with an aperture pattern (i.e. apertures arranged in a formation) configured to define the outer dimensions of the beamlets (or sub-beams) projected towards the target 208. In an embodiment the beam-limiting aperture array 221 is part of the source converter 220. In an alternative embodiment the beam-limiting aperture array 221 is part of the system upbeam of the main device. In an embodiment, the beam-limiting aperture array 221 divides one or more of the sub-beams 211, 210, 213 into beamlets such that the number of beamlets projected towards the target 208 is greater than the number of sub-beams transmitted through the beam former array 272. In an alternative embodiment, the beam-limiting aperture array 221 keeps the number of the sub-beams incident on the beam-limiting aperture array 221, in which case the number of sub-beams may equal the number of beamlets projected towards the target 208.

As shown in **FIG. 2,** in an embodiment the charged particle-optical device 40 comprises a pre-bending deflector array 223 with pre-bending deflectors 223_1, 223_2, and 223_3 to bend the sub-beams 211, 212, and 213 respectively. The pre-bending deflectors 223_1, 223_2, and 223_3 may bend the path of the sub-beams 211, 210, and 213 onto the beam-limiting aperture array 221.

The charged particle-optical device 40 may also include an image-forming element array 222 with image-forming deflectors 222_1, 222_2, and 222_3. There is a respective deflector 222_1, 222_2, and 222_3 associated with the path of each beamlet. The deflectors 222_1, 222_2, and 222_3 are configured to deflect the paths of the beamlets towards the electron-optical axis 204. The deflected beamlets form virtual images (not shown) of source crossover 201s. In the current embodiment, these virtual images are projected onto the target 208 by the objective lens 231 and form probe spots 291, 292, 293 thereon. The charged particle-optical device 40 may also include an aberration compensator array 224 configured to compensate aberrations that may be present in each of the sub-beams. In an embodiment the aberration compensator array 224 comprises a lens configured to operate on a respective beamlet. The lens may take the form or an array of lenses. The lenses in the array may operate on a different beamlet of the multibeam. The aberration compensator array 224 may, for example, include a field curvature compensator array (not shown) for example with micro-lenses. The field curvature compensator and micro-lenses may, for example, be configured to compensate the individual sub-beams for field curvature aberrations evident in the probe spots, 291, 292, and 293. The aberration compensator array 224 may include an astigmatism compensator array (not shown) with micro-stigmators. The micro-stigmators may, for example, be controlled to operate on the sub-beams to compensate astigmatism aberrations that are otherwise present in the probe spots, 291, 292, and 293.

The image-forming element array 222, the aberration compensator array 224, and the pre-bending deflector array 223 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 231 focuses the beamlets onto the surface of the target 208, i.e., it projects the three virtual images onto the target surface. The three images formed by three sub-beams 211 to 213 on the target surface form three probe spots 291, 292 and 293 thereon. In an embodiment the deflection angles of sub-beams 211 to 213 are adjusted to pass through or approach the front focal point of objective lens 231 to reduce or limit the off-axis aberrations of three probe spots 291 to 293. In an arrangement the objective lens 231 is magnetic. Although three beamlets are mentioned, this is by way of example only. There may be any number of beamlets.

In an embodiment a beam separator (not shown) is provided. The beam separator may be downbeam of the source converter 220. The beam separator may be, for example, a Wien filter comprising an electrostatic dipole field and a magnetic dipole field. The beam separator may be upbeam of the objective lens 231. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 204.

In an embodiment a secondary device (not shown) is provided comprising detection elements for detecting corresponding secondary charged particle beams, for example at a remote end of the secondary device which is connected to the main device at a proximate end of the secondary device. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus comprising the secondary device including the associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus, for example close to the proximate end of the secondary device. The secondary projection apparatus subsequently focuses the path of secondary electron beams onto a plurality of detection regions of the electron detection device, for example towards the remote end of the secondary device. The secondary projection apparatus and its associated electron detection device may register and generate an image of the target 208 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. Such a plate may be manufactured using processing suitable for manufacturing microelectromechanical systems (MEMS); such a charged particle-optical component or device may be referred to being made using such MEMS manufacturing techniques and on occasion may be referred to as a MEMS. MEMS are miniaturized mechanical and electromechanical elements that are made using semiconductor fabricating techniques. Any of the elements and components provided in the source converter may be referred to as MEMS or at least may be made using MEMS manufacturing techniques. In an embodiment, the manipulators such as the lenses and deflectors 222_1, 222_2, and 222_3 are controllable, passively, actively, as a whole array, individually or in groups within an array, so as to control the beamlets of charged particles projected towards the target 208.

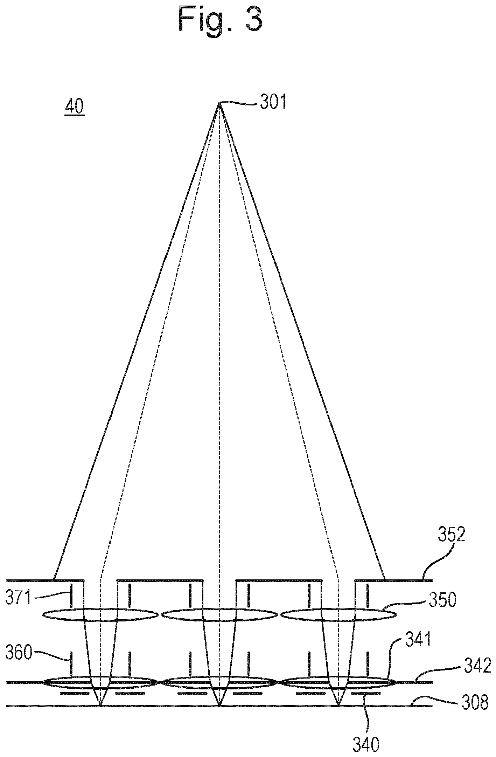

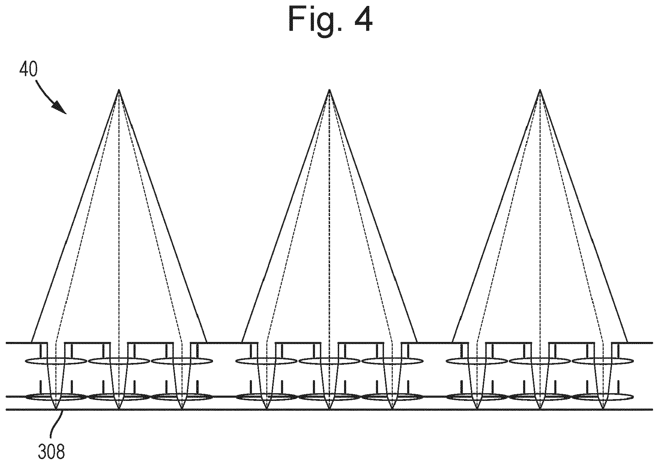

In an embodiment the charged particle-optical device 40 may comprise alternative and/or additional components on the charged particle path, such as lenses and other components some of which have been described earlier with reference to **FIG. 1** and **2**. Examples of such arrangements are shown in **FIG. 3** and **4** which are described in further detail later. A detector is provided to detect charged particles emitted by the sample. The detector may be integrated into the objective lens. The detector may be situated so as to face a sample in use, for example the detector may be on an end of the charged particle device 40 such as the bottom surface of an objective lens array. The detector may comprise an array, for example of detector elements, which may correspond to the array of the primary beams of the beam grid or multibeam arrangement. The detectors (or detector elements) in the detector array may generate detection signals that may be associated with the pixels of a generated image. The condenser lenses, objective lenses and/or detector may be formed as MEMS or CMOS devices and are as such lenses with respect to the different beams of the beam grid. With respect to the beam grid, the condenser lenses, objective lenses and/or detector may be referred to as a condenser lens array, an objective lens array and/or a detector array respectively.

**FIG. 3** is a schematic diagram of another design of an exemplary charged particle-optical device 40. The multibeam charged particle-optical device 40 is an example of the charged particle-optical device 40 of the assessment apparatus 100. The charged particle-optical device 40 may comprise a source 301. Alternatively, the charged particle-optical apparatus (of the assessment apparatus 100) comprises the charged particle-optical device 40 and the source 301, where the source 301 is separate from the charged particle-optical device 40. The charged particle-optical device 40 may comprise an upper beam limiter 352, a collimator element array 371, a control lens array 350, a scan deflector array 360, an objective lens array 341, a beam shaping limiter 342 and a detector array 340. The source 301 provides a beam of charged particles (e.g. electrons), for example as a source beam which may be diverging along the direction towards the sample 308.

The upper beam limiter 352 defines an array of beam-limiting apertures. The upper beam limiter 352 may be referred to as an upper beam-limiting aperture array or an upbeam beam-limiting aperture array. The upper beam limiter 352 may comprise a plate (which may be a plate-like body) in which a plurality of apertures are defined. The upper beam limiter 352 forms the primary beams from the source beam of charged particles emitted by the source 301. As described above, the primary beams may be referred to as sub-beams or beamlets. Portions of the source beam other than those contributing to forming the primary beams may be blocked (e.g. absorbed) by the upper beam limiter 352 so as not to interfere with the primary beams downbeam. The upper beam limiter 352 may be referred to as a primary beam defining aperture array, or a sub-beam defining aperture array.

The collimator element array 371 is provided downbeam of the upper beam limiter 352. Each collimator element collimates a respective primary beam. The collimator element array 371 may be formed using MEMS manufacturing techniques so as to be spatially compact. In some embodiments, exemplified in **FIG. 3,** the collimator element array 371 is the first deflecting or focusing electron-optical arrangement element in the beam path downbeam of the source 301. In another arrangement, the collimator may take the form, wholly or partially, of a macro-collimator. Such a macro-collimator may be upbeam of the upper beam limiter 352 so it operates on the source beam before generation of the multibeam of primary beams (or beam grid of primary beams). A magnetic lens may be used as the macro-collimator.

Downbeam of the collimator element array there is the control lens array 350. The control lens array 350 comprises a plurality of control lenses. Each control lens comprises at least two electrodes (e.g. two or three electrodes, where each respective electrode is a respective plate in which are defined a plurality of apertures) connected to respective potential sources. The control lens array 350 may comprise two or more (e.g. three) plate electrode arrays connected to respective potential sources. The control lens array 350 is associated with the objective lens array 341 (e.g. the two arrays are positioned close to each other and/or mechanically connected to each other and/or controlled together as a unit).

As mentioned, the control lens array 350 is associated with the objective lens array 341. The control lens array 350 may be considered as providing electrodes additional to electrodes of the objective lens array 341. For example, the control lens array 350 may be considered as part of an objective lens array 341 assembly. The additional electrodes of the control lens array 350 allow further degrees of freedom for controlling the electron-optical parameters of the primary beams. In an embodiment the control lens array 350 may be considered to be additional electrodes of the objective lens array 341 enabling additional functionality of the respective objective lenses of the objective lens array 341. In an arrangement such electrodes may be considered part of the objective lens array providing additional functionality to the objective lenses of the objective lens array 341. In such an arrangement, the control lens is considered to be part of the corresponding objective lens, even to the extent that the control lens is only referred to as being a part of the objective lens for example in terms of providing one more extra degrees of freedom to the objective lens. Although the control lens array 350 may be indistinct from and part of the objective lens array 341, in this description the control lens array 350 is considered to be distinct and separate from the objective lens array 341.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures defined therein. For example, the plates may each comprise apertures for respective primary beams of the beam grid.

The scan-deflector array 360 comprising a plurality of scan deflectors may be provided. The scan-deflector array 360 may be formed using MEMS manufacturing techniques. Each scan deflector scans a respective primary beam over the sample 308. In an embodiment, the scanning deflectors described in EP2425444, which document is hereby incorporated by reference in its entirety specifically in relation to scan deflectors, may be used to implement the scan-deflector array 360.

The objective lens array 341 comprising a plurality of objective lenses is provided to direct the primary beams onto the sample 308. Each objective lens comprises at least two electrodes (e.g. two or three electrodes) connected to respective potential sources.

The objective lens array may form part of an objective lens array assembly along with any or all of the scan-deflector array 360, control lens array 350 and collimator element array 371. The objective lens array assembly may further comprise the beam shaping limiter 342. The beam shaping limiter 342 defines an array of beam-limiting apertures. The beam shaping limiter 342 may be referred to as a lower beam limiter, lower beam-limiting aperture array or final beam-limiting aperture array.

In an arrangement, the beam shaping limiter 342 is structurally integrated with an electrode of the objective lens array 341. Desirably, the beam shaping limiter 342 is positioned in a region of low electrostatic field strength. Each of the beam-limiting apertures is aligned with a corresponding objective lens in the objective lens array 341.

In an embodiment, the charged particle-optical device 40 is configured to control the objective lens array assembly (e.g. by controlling potentials applied to electrodes of the control lens array 350) so that a focal length of the control lenses is larger than a separation between the control lens array 350 and the objective lens array 341. The control lens array 350 and objective lens array 341 may thus be positioned relatively close together, with a focusing action from the control lens array 350 that is too weak to form an intermediate focus between the control lens array 350 and objective lens array 341. The control lens array and the objective lens array operate together to define a combined focal length to the same surface. Combined operation without an intermediate focus may reduce the risk of aberrations. In other embodiments, the objective lens array assembly may be configured to form an intermediate focus between the control lens array 350 and the objective lens array 341.

An electric power source may be provided to apply respective potentials to electrodes of the control lenses of the control lens array 350 and the objective lenses of the objective lens array 341.

The detector array 340 is provided to detect charged particles emitted from the sample 308. The detected charged particles may include any of the charged particles (e.g. signal particles) detected by a scanning electron microscope, including secondary (e.g. emitted) and/or backscattered electrons from the sample 308. The detector array 340 may be an array provided on the surface of the charged particle-optical device 40 facing the sample 308, e.g. on the bottom surface of the charged particle-optical device 40. Alternatively (or additionally) the detector array 340 may be upbeam of the bottom surface of the charged particle-optical device 40, for example in or upbeam of the objective lens array 341 or the control lens array 350. The elements of the detector array 340 may correspond to the primary beams of the beam grid. The signal generated by detection of an electron by an element of the detector array 340 may be transmitted to a processor for generation of an image. The signal may correspond to a pixel of an image.

In other embodiments both a macro scan deflector and the scan-deflector array 360 are provided. In such an arrangement, the scanning of the primary beams over the sample 308 surface may be achieved by controlling the macro scan deflector and the scan-deflector array 360 together, desirably in synchronization.

In an embodiment, as exemplified in **FIG. 4**, there are multiple charged particle optical devices 40, e.g. there is an array of multibeam charged particle-optical devices 40. The array may comprise a plurality of any of the charged particle-optical devices 40 described herein. For example, as shown in **FIG. 4,** the array comprises a plurality of the multibeam charged particle-optical device 40 depicted in **FIG 3.** Each charged particle-optical device 40 of the array focuses respective primary beams simultaneously onto different regions of the same sample.

Any number of charged particle-optical devices 40 may be used in the array . Each charged particle-optical device 40 in the array may be configured in any of the ways described herein when referring to a single charged particle-optical device 40. Details of such an arrangement is described in EPA 20184161.6 filed 6 July 2020 which, with respect to how the objective lens is incorporated and adapted for use in the multi-device arrangement is hereby incorporated by reference.

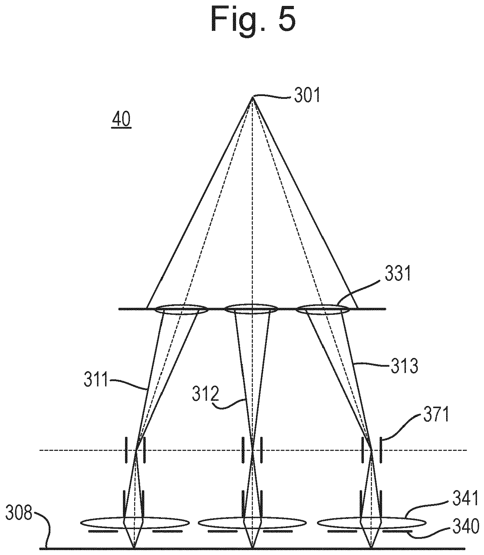

An arrangement of the charged particle-optical device 40 may have the arrangement shown in and described with reference to **FIG. 5**. Same references take the same features and description as supplied with reference to **FIG 3** unless stated to the contrary.

The charged particle-optical device 40 may comprise a condenser lens array 331 upbeam of the objective lens array arrangement 341, as disclosed in EP application 20158804.3 filed on 21 February 2020 which is hereby incorporated by reference so far as the description of the multibeam device with a collimator and its components. The condenser lens array 331 may replace the collimator array 371. The condenser lens array 331 may comprise a plurality of apertures arrays, for example three aperture arrays for an Einzel lens array. The aperture arrays may be electrode plates in which are defined apertures for respective primary beams of the beam grid. The most upbeam aperture array may be a beam limiting aperture array for defining the primary beams of the beam grid from the source beam. The beam limiting aperture array may be upbeam of the most upbeam electrode plate of the condenser lens array 331 or may be the most upbeam electrode plate of the condenser lens array 331. The condenser lens array 331 or its associated beam limiting aperture array may focus the primary beams towards an intermediate focus. The intermediate foci of the different primary beams may be at an intermediate focus plane which may be curved.

The collimator element array 371 may be at or close to the intermediate focus array. The collimator element array 371 may operate on the primary beams to substantially collimate the primary beams. The collimator element array 371 may be one or more deflector arrays and/or lens arrays, in which the constituent aperture arrays are curved and/or are any other suitable collimator array.

The charged particle-optical device 40 shown and described with reference to **FIG. 5** may comprise some of the same features as the charged particle-optical device 40 shown in and described with reference to **FIG. 3**. For example, this may be the case in terms of the objective lens array 340 the scan deflector array 360 and the detector array 340. The charged particle-optical device 40 shown in and described with reference to **FIG. 5** may comprise a control lens array 350. The control lens array 350 may be positioned within the charged particle-optical device 40 and configured in the same way as the control lens array of the charged particle-optical device 40 shown in and described with reference to **FIG. 3**. For instance, in the charged particle-optical device 40 shown in and described with reference to **FIG. 5,** a control lens array 350 may be associated with the objective lens array 341 as described with reference to the charged particle-optical device depicted in **FIG. 3**. In an embodiment the control lens array may be comprised by additional plates of the objective lens array 341. The upper beam limiter 352 and the beam shaping limiter 342 of the charged particle-optical device 40 depicted in **FIG. 3** are not necessarily present in the charged particle-optical device 40 depicted in **FIG. 5** because of the presence of the beam limiting aperture array in or associated with the condenser lens array 331.

The detector (or detector array 340) may be integrated into the objective lens array 341 and the control lens array 550 (when present as it is not depicted in **FIG. 5).** The detector may have more than one detector at different positions along the paths of the primary beams of the multibeam, or along the path of the beam grid of the primary beams. In an arrangement the detector array 340 may be the most downbeam surface of the charged particle-optical device 40. In another arrangement, the detector array be located upbeam of the objective lens array 341, for example upbeam of the control lens array 350. In an arrangement the objective lens arrangement may comprise a separator array, e.g. an electrostatic deflector array and/or a magnetic deflector array, which may cancel the deflection of the other deflections applied to primary beams and may have a cumulative deflection to deflect signal particles towards the detector array 340 for example when the detector array is located above the objective lens arrangement, such as upbeam of the control lens array 350. In an arrangement the detector may be located in similar locations in the charged particle-optical device 40 depicted in **FIG. 5** as described with reference to and as shown in the charged particle-optical device of **FIG. 3**.

A charged particle-optical device array having multiple multibeam devices has been described with reference to the multibeam device of **FIG. 3,** as shown in **FIG. 4.** In another arrangement of a charged particle-optical device array, the charged particle-optical devices 40 may have the same features as the charged particle-optical device described with reference to **FIG. 5**. The multiple multibeam charged particle-optical devices 40 may be arranged in an array of multibeam devices. Such an arrangement is shown and described in EP Application 20158732.6 filed on 21 February 2020 which is hereby incorporated by reference with respect to the multi-device arrangement of a multibeam apparatus featuring the design of multibeam device disclosed with a collimator at, or even proximate to, an intermediate focus. A further alternative design of multibeam apparatus comprises multiple single beam devices.

The charged particle-optical device 40 may be a component of an assessment apparatus 100 (e.g. for inspection, metrology, metro-inspection or any other type of assessment), or part of an e-beam lithography apparatus or other type of charged particle induced sample patterning apparatus. The charged particle optical device 40 may be used in a number of different applications that include electron microscopy in general, not just scanning electron microscopy, such as for assessment applications, and lithography.

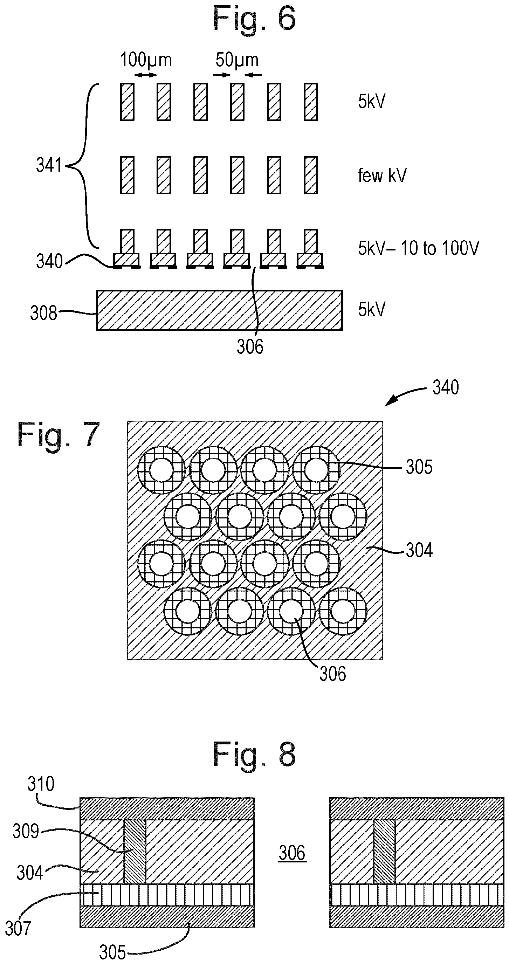

An exemplary embodiment of a detector integrated into an objective lens array is shown in **FIG. 6.** Same features take the same or corresponding reference numbers and the same description unless stated expressly to the contrary. The arrangement shown in **FIG. 6** illustrates a portion of an objective lens array 341 in schematic cross-section which may similar to or the same as the objective lens array 341 shown in and described with reference to **FIGs. 3 to 5.**

In an embodiment, the detector array 340 is comprised in a detector module which may take the form of at least a detector substrate. The detector module may comprise the detector elements 305 (i.e. a plurality of detector elements 305, for example arranged in the detector array, for example as an array of detector elements). The detector elements 305 may be sensor elements. The detector elements 305 may be in the form of detector electrodes, such as capture electrodes which may be charge detectors for detecting charge such as a metal layer. Additionally or alternatively, the detector elements 305 may be in the form of semiconductor detector elements, such as PIN detector elements. Additionally or alternatively, the detector elements 305 may be in the form of scintillating detector elements. The array of detector elements 305 may be a plurality of detector elements 305 arranged in a pattern or two-dimensional arrangement, for example arranged in a pattern or two dimensional arrangement over a surface. The detector module may be proximate a sample 308 position, such as provided to the most downbeam surface of the electron-optical device 40. For example, the detector module may be provided to the most downbeam surface of the objective lens array 341.

**FIG. 7** is a view of the most downbeam surface of the detector module. As mentioned the detector module is at least comprised by the detector substrate 304. The array of detector elements 305 (such as capture electrodes) are defined in or on the surface of the detector substrate 304. In the detector elements 305, there may be defined a beam aperture 306. For example, in the detector elements 305, there may be defined a beam aperture 306 so that a surface of the detector elements 305 each surround a respective beam aperture 306. The beam apertures 306 may be formed by etching through substrate 304. In the arrangement shown in **FIG. 7,** the detector elements 305 and the beam apertures 306 are shown in a hexagonal close-packed array. The beam apertures 306 can also be differently arranged, e.g. in a rectangular array.

**FIG. 8** depicts at a larger scale a part of the detector module in cross-section. Detector elements 305 (i.e. capture electrodes) form the most downbeam surface of the detector module 340, i.e. a surface of the detector module 340 that is most close to the sample, for example, most close to the sample in operation. In an arrangement there is a logic layer 307 between the detector elements 305 and the main body of the silicon substrate 304. The logic layer 307 may be wholly, or at least partly, in a logic layer on or in the other major surface of the detector substrate 304 or a layer in an adjoining substrate, such as a wiring and/or logic substrate. Connection is made to the logic layer in or on the other major surface and/or the adjoining substrate through the detector substrate 304 though a via extending through the detector substrate 304. Logic layer 307 may include amplifiers, e.g. Trans Impedance Amplifiers, analogue to digital converters, and readout logic. In an embodiment, there is one amplifier and one analogue to digital converter per detector element 305 (i.e. per capture electrode). A circuit featuring these elements may be comprised in a unit area referred to as a cell that is associated with an aperture. The detector module may comprise several cells each associated with an aperture. The cells may have a similar shape. The detector substrate 304 and the logic substrate comprising the logic layer 307 and the detector electrodes 305 may comprise multilayer structures such as CMOS structures, and may be manufactured using a CMOS processing.

In operation, the assessment apparatus 100 generates strong electric fields between electrodes of the objective lens array 341. Significant electric fields may also be generated between electrodes elsewhere in the system. Strong electric fields are associated with correspondingly strong electrostatic pressures. Electrostatic pressure is proportional to the field energy density, $\eta_E$, which in turn is proportional to $E^2$ according to

$$\eta_E = \frac{1}{2}\varepsilon E^2$$

(where $\varepsilon$ is the electric permittivity and $E$ is the electric field strength). The electrostatic pressure thus increases quickly with increasing $E$.

In some arrangements, the electrostatic pressure causes a change in shape and/or position of one or more electrodes of the assessment apparatus 100. The change in shape and/or position of electrodes may be referred to as electrode deformation. This electrode deformation may be referred to as electrostatically-induced mechanical distortion.

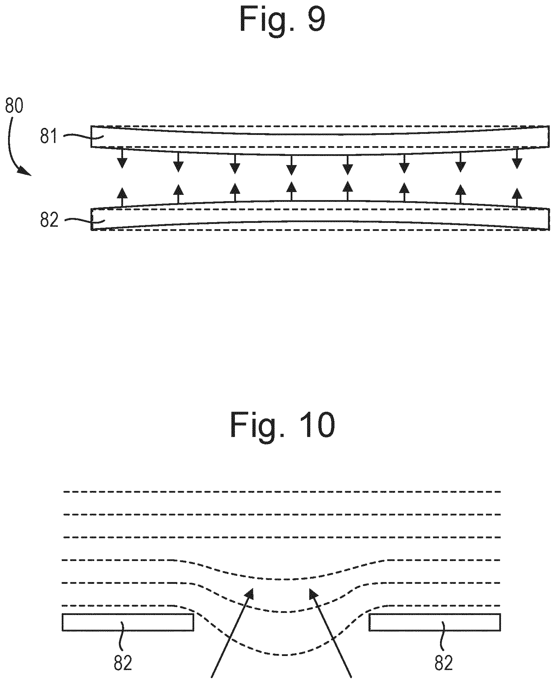

**FIG. 9** depicts an exemplary schematic arrangement of electrodes 81 and 82 to demonstrate such electrode deformation schematically. The electrodes 81, 82 are planar. Electrodes 81, 82 are part of an electron-optical arrangement 80. The electron-optical arrangement 80 may form, or may form part of, an objective lens array, such as the common objective lens arrays 341. Additionally or alternatively, the schematic electron-optical arrangement 80 may be, or may form part of, a condenser lens array (e.g. the condenser lens 331), a collimator array (e.g. the collimator array 371), a scan deflector array (e.g. the scan deflector array 360), or a source conversion unit (e.g. source conversion unit 220). This is because, in such arrangements, the electrodes may be plates.

For ease of depiction, the electrodes 81, 82 are shown not to scale and without apertures. Broken lines, that are shaped as rectangles, depict an schematic representation cross-sectional shape of the plates used as electrodes 81, 82 while the system is turned off (i.e. when no electric field is present between internal surface electrodes 81, 82). For the purpose of the schematic depiction, it is considered that the electrodes 81, 82 are able to support their own weight, for example, that the plates 81, 82 used as the electrodes do not deform under the influence of a gravitational field. This may be referred to as an initial state or undeformed state. As mentioned, the electrodes 81, 82 may be plates. The electrodes 81, 82 may be conductive plates. The electrodes 81, 82 may comprise an upbeam plate 81 (or a first plate 81) and a downbeam plate 82 (or a second plate 82). The references to upbeam and downbeam to the plates are labels of convenience although one of the plates should be upbeam of the other.

In the electron-optical arrangement 80, the upbeam plate 81 and the downbeam plate 82 are substantially planar in an initial state. For example, the upbeam plate 81 and the downbeam plate 82 are substantially planar before application of an electric field or otherwise in an electric field-free state between the internal surfaces of the upbeam plate 81 and the downbeam plate 82.

Henceforth, the term "mid-surface" will be used in relation to the upbeam plate 81 and the downbeam plate 82. As used herein, a mid-surface of a plate is a virtual surface that passes through the center of mass (i.e. the centroid) of the plate, and is substantially parallel to upbeam and downbeam surfaces of the plate. When a plate is deformed (e.g. bowed), the plate will be in tension on one side of the mid-surface and in compression on the other side of the mid-surface. That is, the mid-surface of the plate is the neutral plane of the plate.

In the electric field-free state, the upbeam plate 81 may be planar, and the mid-surface of the upbeam plate 81 may be substantially planar (i.e. flat). In the electric field-free state, the upbeam plate 81 may be undeformed. In the electric field-free state, the downbeam plate 82 may be planar, and the mid-surface of the downbeam plate 82 may be substantially planar (i.e. flat). In the electric field-free state, the downbeam plate 82 may be undeformed. In the electric field-free state, the upbeam plate 81 may be substantially parallel to the downbeam plate 82 (e.g. the mid-surface of the upbeam plate 81 may be substantially parallel to the mid-surface of the downbeam plate 82). In the electric field-free state, the mid-surface of the upbeam plate 81 may be perpendicular to the path of the multibeam and the mid-surface of the downbeam plate 82 may be perpendicular to the path of the multibeam. In the electric field-free state, the mid-surface of the upbeam plate 81 may be parallel to the sample and the mid-surface of the downbeam plate 82 may parallel to the sample or general plane of a surface of the sample or the intended sample position. The mid-surface of the upbeam plate 81 in the electric field-free state may be referred to as an initial mid-surface of the upbeam plate 81.

The upbeam plate 81 and the downbeam plate 82 may be arranged in series along the path of the beam grid. In the upbeam plate 81 and the downbeam plate 82 are defined apertures that are aligned with the primary beam paths. In the upbeam plate 81, there may be defined a plurality of apertures arranged in a two-dimensional array. In the downbeam plate 82, there may be defined a plurality of apertures arranged in a two-dimensional array. Each of the apertures defined in the upbeam plate 81 and the downbeam plate 82 is for the passage of one or more of a plurality of primary beams of charged particles through the respective plate. The apertures may be positioned in the upbeam plate 81 and the downbeam plate 82 so an aperture having the same position in the array of apertures in the upbeam plate 81 as the array of apertures in the downbeam pate 82 may be for the path of the same primary beam in the beam grid.

The apertures in the upbeam plate 81 may be referred to as first apertures, and the apertures in the downbeam plate may be referred to as second apertures. In this context, the terms "first" and "second" are used merely as labels so that the apertures in the upbeam plate 81 and the apertures in the downbeam plate 82 can be distinguished easily when the apertures are described in further detail below. The following description in relation to **FIG. 9** predominantly refers to an arrangement in which there are a plurality of first apertures and a plurality of second apertures. However, in some arrangements, there may be only a single first aperture and only a single second aperture.

When a potential difference is applied between the upbeam plate 81 and the downbeam plate 82, the apertures defined in the upbeam beam plate 81 and downbeam plate 82 have an electron-optical operation of the respective beams of the beam grid passing therethrough, for example a lensing effect. Such a lensing effect is applied to a beam of charged particles passing through such an aperture when an electric field is present on one side of the aperture. In the arrangement shown in and described with reference to **FIG. 9,** when the potential difference is applied between the plates 81, 82 an electric field is present between the surfaces of the upbeam plate 81 and the downbeam plate 82 that face each other (i.e. between the internal surfaces of the upbeam plate 81 and the downbeam plate 82). The electric field is on each of these facing surfaces and around each aperture defined in each of the facing surfaces. Each aperture (for example in the facing surfaces of the upbeam plate 81 and the downbeam plate 82 when the electric field is present between the internal surfaces of the plates 81, 82) operating in this way may be referred to as an elementary lens or aperture lens. The focal length, $f,$ of such an elementary lens depends on the energy of the primary beam, $U,$ and the electric field strength, $E$, according to $f = 4U/E.$

In arrangements where the electron-optical arrangement 80 is a lens arrangement (e.g. an objective lens array) having two plates 81, 82 only, the electron-optical arrangement comprises two elementary lenses for each beam path of the beam grid. An upbeam elementary lens (a first aperture lens) is defined by an aperture in the surface of the upbeam plate 81 (i.e. the electrode closer to the source and further from the sample) facing the downbeam plate 82. The downbeam elementary lens is defined by an aperture in the downbeam plate 82 (i.e. the electrode further from the source and closer to the sample) facing the upbeam plate 81. The beam energy at the surface of a plate is defined by the potential applied to the respective surface of the plate. The assessment apparatus 100 may comprise an electron-optical arrangement power supply (not shown) configured to apply a potential between the upbeam plate 81 and the downbeam plate 82.

If the lens arrangement is a decelerating lens arrangement, the first elementary lens will be a negative lens and the second elementary lens will be a positive lens. The second elementary lens will be stronger (i.e. a smaller focal length, $f$) than the first elementary lens because the beam energy $U$ of the primary beam is lower when the primary beam reaches the second elementary lens (i.e. after deceleration).

Conversely, if the lens arrangement is an accelerating lens arrangement, the first elementary lens will be a positive lens and the second elementary lens will be a negative lens. The first elementary lens will be stronger (i.e. a smaller focal length $f$) than the second elementary lens in this case because the beam energy $U$ of the primary beam is higher when the primary beam reaches the second elementary lens (i.e. after acceleration).

Objective lens arrangements of the present disclosure are typically operated as decelerating lens arrangements with a large difference in beam energy between the first and second elementary lenses. This means that the second elementary lens in each objective lens arrangement is much stronger than the first elementary lens and largely dominates the properties of the objective lens arrangement. For example, in one implementation the beam energy at the upbeam plate 81 is 30 keV and the beam energy at the downbeam plate 82 is 2.5 keV, making the first elementary lens 12 times weaker than the second elementary lens. An example of a downbeam plate 82 in which an aperture defines a downbeam elementary lens is depicted schematically in **FIG. 10,** along with the associated equipotentials. The arrows schematically represent the direction of forces (perpendicular to the equipotentials) that would be applied to charged particles passing through the elementary lens.

When a potential difference is applied between the upbeam plate 81 and the downbeam plate 82, a strong electric field is generated between the facing surfaces (or internal surfaces) of the upbeam plate 81 and the downbeam plate 82. As explained above, this means that an electrostatic pressure is exerted on the upbeam plate 81 and the downbeam plate 82. Thus an electrostatic force is exerted between the facing surfaces (or internal surfaces) of the upbeam plate 81 and the downbeam plate 82. That is, an electrostatic force is exerted on the upbeam plate 81 in the direction of the downbeam plate 82; and an electrostatic force is exerted on the downbeam plate 82 in the direction of the upbeam plate 81. The electrostatic force exerted on the upbeam plate 81 is equal and opposite the electrostatic force exerted on the downbeam plate 82.

The solid line rectangles in **FIG. 9** depict example cross-sectional shapes of the upbeam plate 81 and the downbeam plate 82 during operation, i.e. when an electric field is present between the facing surfaces of the upbeam plate 81 and the downbeam plate 82, for example when the upbeam plate 81 and the downbeam plate serve as electrodes. On application of the electrostatic force between the facing surfaces of the upbeam plate 81 and the downbeam plate 82, the upbeam plate 81 and downbeam plate deform. **FIG. 9** depicts a typical case where electrodes deform, for example bow, into a region of high electric field strength. That is, a radially inward portion (for example, a radially inward portion relative to a path of the beam grid) of the upbeam plate 81 deforms in the direction of the downbeam plate 82, and a radially inward portion (for example, a radially inward portion relative to a path of the beam grid) of the downbeam plate 82 deforms in the direction of the upbeam plate 81.

The deformation caused by the electrostatic forces generated by the electric field operating on the facing surfaces of the upbeam plate 81 and the downbeam plate 82 cause a distance between the radially inward portion of the upbeam plate 81 and the radially inward portion of the downbeam plate 82 to be reduced. The radially inward portion of the upbeam plate 81 may be a portion of the upbeam plate 81 radially inward of an edge portion of the upbeam plate 81 at which the upbeam plate 81 is supported. The radially inward portion of the downbeam plate 82 may be a position radially inward of an edge portion of the downbeam plate 82 at which the downbeam plate 82 is supported. This mode of electrode deformation may be referred to as a bow. Such a bow may be a mode of distortion having a parabolic or approximately parabolic form. In bow deformation, the consequential distortion may be approximated to vary as a function of the square of radial position. The bow may be radially symmetrical, for example about the path of the beam grid.

Electrode deformation in the objective lens array, 341, may affect primary beams of the multibeam. Deformation of the upbeam plate 81 may displace each first aperture of the plurality of first apertures in a direction parallel to the path of the beam grid towards the sample. The extent to which a first aperture is displaced depends on the radial position of the first aperture. Thus, displacement in the direction parallel to the path of the beam grid towards the sample may be different for different first apertures of the plurality of first apertures. That is, after deformation of the upbeam plate 81, there may be a spatial variance in the distances between each of the plurality of first apertures and the initial mid-surface (of the upbeam plate 81). For example, after deformation of the upbeam plate 81, there may be a spatial variance in the distances between each of the plurality of first apertures at the mid-surface of the first plate 81 and the initial mid-surface (of the upbeam plate 81). As a result, after deformation of the upbeam plate 81, there may be a spatial variance between each of the first apertures and the sample. The same applies for the downbeam plate 82. Consequently, the deformation of the upbeam plate 81 and the downbeam plate 82 may contribute to field curvature. Field curvature is where the focus plane is not flat, which may lead to focus errors at a planar surface of the sample 308. In most cases, the effects of deformation of the upbeam plate 81 and deformation of the downbeam plate 82 will be cumulative, rather than tending to cancel out.

In addition to displacing the first and second apertures in the direction parallel to the path of the beam grid towards the sample, the deformation of the upbeam plate 81 and the downbeam plate 82 may cause the electric field between the 81 upbeam plate and the downbeam plate 82 to be changed. Specifically, the deformation of the upbeam plate 81 and the downbeam plate 82 may introduce a radial component to the field (i.e. a component that is perpendicular to the path of the beam grid towards the sample). The radial component of the field may result in a displacement of the transverse position of the probe spot on the sample.

In arrangements where the electron-optical arrangement 80 comprises more than two plates 81, 82 in series along each primary beam path, the plate closest to the sample may not be the plate that provides the strongest lensing effect. For example, in a decelerating Einzel lens configuration with three electrodes (e.g. plates) in series along each primary beam path, the middle electrode may apply the strongest lensing effect (because the beam energy is lowest at the middle electrode). Other arrangements having more than two electrodes (e.g. plates) may be used, including arrangements in which three or more electrodes are arranged asymmetrically along the primary beam paths (with nonuniform spacings between different pairs of adjacent electrodes). Using more than two electrodes will provide more degrees of freedom for controlling primary beams in the multibeam. Any electrode of an electron-optical arrangement that is provided between regions of different field strength will be subject to forces from electrostatic pressure that may cause deformation of the electrode.

In arrangements having three or more electrodes, two or more distinct volumes may be defined between respective pairs of adjacent electrodes. Deformation of electrodes on either side of such volumes may lead to changes in the shape of these volumes. The changes in shape of a volume may be described as a deformation between electrodes on either side of the volume, which may be described as perturbation away from their relative unperturbed states. A change in shape of a volume will lead to a corresponding variation in electric field in the volume as a function of position in the volume. The electric field will be stronger, for example, in regions where the electrodes are closer together (e.g. in a central region) compared to regions where the electrodes are further apart (e.g. in peripheral regions). The variation in electric field as a function of position in a volume may contribute to field curvature by causing a corresponding variation in the strength of elementary lenses that depend on the electric field in the volume.

Different electrodes (plates) may be deformed in different ways, leading to a wide range of potential variations in shapes of electrodes and volumes between electrodes. There may therefore be many contributions to overall electrode deformation in an electron-optical arrangement such as the objective lens array.

The magnitude of the deformation of the upbeam plate 81 and the downbeam plate 82 depends on the magnitude of the electric field between the upbeam plate 81 and the downbeam plate 82 (for example, between the facing surfaces of the upbeam plate 81 and the downbeam plate 82), which is dependent on the potential difference between the upbeam plate 81 and the downbeam plate 82. The magnitude of the deformation also depends on the flexural stiffness of the upbeam plate 81 and the downbeam plate 82. The flexural stiffness of a circular plate may be defined as $D = \frac{Yh^3}{12(1-v^2)}$, where: $D$ is the flexural stiffness of the plate; $Y$ is the Young's Modulus of the material from which the plate is formed; $h$ is the thickness of the plate; and $v$ is the Poisson's Ratio of the material from which the plate is formed. Thus, the magnitude of deformation may be reduced by forming the upbeam plate 81 and the downbeam plate 82 of a material with a higher stiffness. However, forming the upbeam plate 81 and the downbeam plate 82 of a material with a higher stiffness would require the adoption of new manufacturing techniques, and so is undesirable. The magnitude of deformation can also be reduced by increasing a thickness of the upbeam plate 81 and a thickness of the downbeam plate 82. However, in the electron-optical arrangement 80 in which the upbeam plate 81 and the downbeam plate 82 are disposed (e.g. the objective lens array 341), there may be a limited amount of space available. Thus, it may not be possible to increase the thickness of the upbeam plate 81 and the downbeam plate 82, or increasing the thickness of the upbeam plate 81 and the downbeam plate 82 may require the electron-optical arrangement 80 to be reconfigured. It may not be desirable for the thickness of the upbeam plate 81 and the downbeam plate 82 to be increased.

It is possible to configure the electron-optical arrangement 80 to compensate for a predicted effect on the primary beams from a predicted electrode deformation in the electron-optical arrangement 80. The electron-optical arrangement 80 may be provided with a hardware correction. In some arrangements, the hardware correction comprises variations in a characterizing parameter of the apertures and relative to other apertures comprised in the array. Such characterizing parameters may include: size, shape and relative position of an aperture in its respective aperture array (e.g. nominal position). For example, the apertures have variations in their sizes (e.g., diameters where the apertures are circular) as defined in one or more of the electrodes as a function of position in each electrode. Varying the sizes of apertures in the electrodes can compensate for changes in field curvature.

Finite manufacturing tolerances limit the accuracy of electrode deformation prediction. Finite manufacturing tolerances lead to small but significant variations between different manufactured instances of the electron-optical arrangement 80, such as differences in electrode thicknesses and/or aperture sizes. These variations can affect the stiffness of the electrodes 80, 81, thus affecting the deformation of the electrodes 80, 81 for a given electrostatic pressure. This variability means that hardware corrections of the type described above may not achieve optimal compensation. For typical implementations of the type shown in **FIG. 3,** it is expected that electrode deformation could lead to surface displacements of several 10s of microns in the direction parallel to the path of the beam grid towards the sample. If a budget defocus amount of 100nm is allocated to this effect, this would imply that electrode deformation should be reproducible to within 1% if a hardware correction (e.g. by varying aperture diameters) is to be effective. It is undesirable to be constrained to such tight manufacturing tolerances. For some arrangements, the electrode deformation is expected to be much smaller, but it is particularly desirable in such arrangements to support tunable landing energy. Tuning landing energy leads to significant changes in the electrostatic field in the objective lens array, which may again lead to hardware corrections being inadequate.

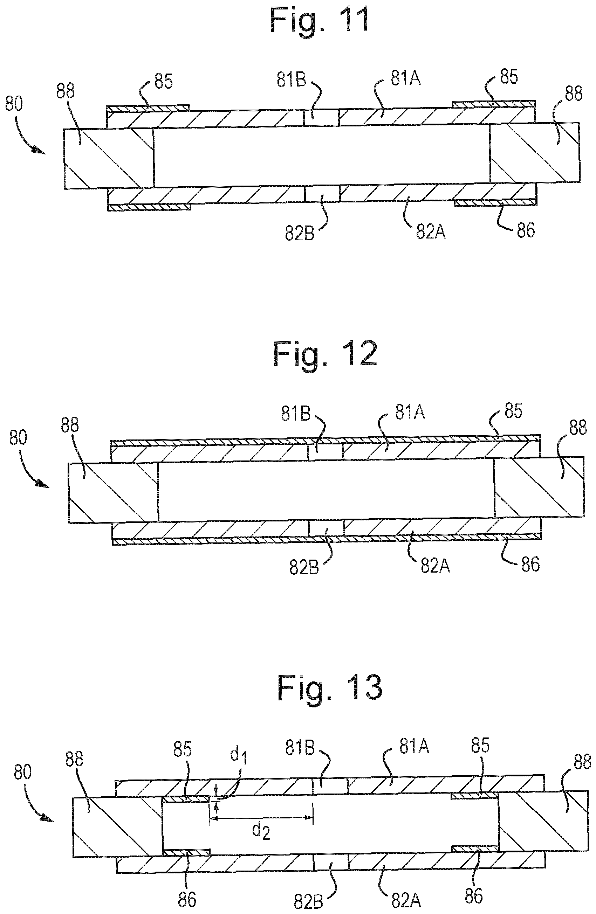

The present disclosure relates to reducing the deformation of the electrodes 81, 82 in the electron-optical arrangement 80 when a potential difference is applied between the electrodes 81, 82. The electron-optical arrangement 80 is for a charged particle-optical device, such as the charged particle-optical devices 40, shown in and described in relation to **FIGS. 2 to 5.** The charged particle-optical device 40 may be configured to operate on at least one beam of charged particles, for example a plurality of primary beams such as a beam grid. The electron-optical arrangement 80 may be, or may be part of, an objective lens array (e.g. the objective lens array 341). Alternatively, the electron-optical arrangement 80 may be, or may be part of, a condenser lens array (e.g. the condenser lens array 350), a collimator array (e.g. the collimator array 371), the scan deflector array (e.g. the scan deflector array 360) or a source converter, such as the source conversion unit 220. Embodiments of the electron-optical arrangement 80 are depicted in **FIGS. 11** to **14C.** While this description focuses on electron-optical arrangement 80, it will be appreciated that the arrangement 80 may be configured for use with other types of charged particles. That is, the arrangement 80 may generally be referred to as a charged particle-optical arrangement.

The electron-optical arrangement 80 comprises the upbeam plate 81 (an electrode) which defines at least one first aperture for passage of at least one beam therethrough. The electron-optical arrangement 80 further comprises the downbeam plate 82 (for example another electrode) which defines at least one second aperture for passage of at least one beam therethrough.

The electron-optical arrangement 80 further comprises an actuator arrangement. The actuator arrangement is configured to apply a force to the upbeam plate 81. Such an actuator arrangement may comprise one or more upbeam plate actuators 85. The one or more upbeam plate actuators 85 may form, or may form part of, an upbeam plate actuator arrangement. In the case that the actuator arrangement comprises actuators other than the one or more upbeam plate actuators (e.g. one or more upbeam plate actuators 85 and one or more downbeam plate actuators 86), the upbeam plate actuator arrangement may be considered to be a sub-arrangement of the actuator arrangement. In addition, or alternatively, to the one or more upbeam plate actuators 85, the actuator arrangement may comprise one or more downbeam plate actuators 86 configured to apply a force to the downbeam plate 82. The one or more downbeam plate actuators 86 may form, or may form part of, a downbeam plate actuator arrangement. In the case that the actuator arrangement comprises actuators other than the one or more downbeam plate actuators 86 (e.g. one or more upbeam plate actuators 85 and one or more downbeam plate actuators 86), the downbeam plate actuator arrangement may be considered to be a sub-arrangement of the actuator arrangement. The actuator arrangement will be described in further detail below.

The upbeam plate 81 may comprise a single (i.e. one) first aperture and the downbeam plate 82 may comprise a single (i.e. one) second aperture. In some embodiments, the first aperture is configured to permit passage of the plurality of beams therethrough, and the second aperture is configured to permit passage of the plurality of beams therethrough. For example, the first aperture may be configured to permit passage of substantially all of the plurality of beams therethrough. The second aperture may be configured to permit passage of substantially all of the plurality of beams therethrough. In an example, the upbeam plate 81 may comprise only one aperture and the downbeam plate 82 may comprise only one aperture. In other embodiments, the upbeam plate 81 defines a plurality of first apertures, and the downbeam plate 82 defines a plurality of second apertures. Although there may be a single aperture defined in the upbeam plate 81 and a single aperture defined in the downbeam plate 82, reference is made for the description in relation to the embodiments shown and depicted in **FIGs 11 to 14C** to a plurality of first apertures as a first aperture array and a plurality of second apertures as a second aperture array. However, such disclosure is intended to also apply to a single aperture in each of the plates 81, 82.

In the embodiments depicted in **FIGS. 11 to 14C,** the electron-optical arrangement 80 is adapted to be used in a multibeam charged particle-optical device 40 configured to operate on a plurality of beams of charged particles in a beam grid. Each of the first apertures of the plurality of first apertures may be for the passage of one or more of the plurality of beams through the upbeam plate 81. Each of the first apertures of the plurality of first apertures may be for the passage of only one of the plurality of beams through the upbeam plate 81. Similarly, each one of the plurality of second apertures may be for the passage of one or more of the plurality of beams through the downbeam plate 82. Each of the second apertures of the plurality of second apertures may be for the passage of only one of the plurality of beams through the downbeam plate 82.

The one or more first apertures may be defined in a beam portion 81B (or beam area or aperture area) of the upbeam plate 81. The one or more second apertures may be defined in a beam portion 82B of the downbeam plate 82. The beam portion 81B of the upbeam plate 81 may be an inner portion of the upbeam plate 81. The beam portion 82B of the downbeam plate 82 may be an inner portion of the downbeam plate 82. The inner portions of the upbeam and downbeam plates 81, 82 may be intermediate portions, for example central portions, for example, radially central portions.

As explained above, the upbeam plate 81 and the downbeam plate 82 may be substantially planar in an initial state or a field-free state, for example when no electric field is present between the facing surfaces of the upbeam plate 81 and the downbeam plate 82. A mid-surface of the upbeam plate 81 in the initial state or the field-free state (i.e. when no electric field is present between the facing surfaces of the upbeam plate 81 and the downbeam plate 82, and the upbeam plate 81 is undeformed), may be referred to as an initial mid-surface. During operation, for example assessment of a sample, the initial mid-surface may be parallel to the sample. When the upbeam plate 81 and the downbeam plate 82 are undeformed (i.e. when there is not an electric field present between the upbeam plate 81 and the downbeam plate 82), the mid-surface of the upbeam plate 81 may be substantially parallel to the mid-surface of the downbeam plate.

The upbeam plate 81 and the downbeam plate 82 may be arranged to face one another. The upbeam plate 81 comprises an upbeam surface (or an external surface) and a downbeam surface (or an internal surface). The internal surface of the upbeam plate 81 faces the downbeam plate 82. The external surface of the upbeam plate 81 is opposite to the internal surface of the upbeam plate 81. The downbeam plate 82 comprises an upbeam surface (or an internal surface) and a downbeam surface (or an external surface). The internal surface of the downbeam plate 82 faces the upbeam plate 81. The external surface of the downbeam plate 82 is opposite to the internal surface of the downbeam plate 82. So the downbeam surface of the upbeam plate 81 faces an upbeam surface of the downbeam plate 82.

In the embodiments depicted in **FIGS. 11 to 14C,** the upbeam plate 81 is upbeam of the downbeam plate 82, for example along the path of the beam grid, for example along a path of the charged particles between the source and the sample. That is, the upbeam plate 81 is closer to the source than the downbeam plate 82 and the downbeam plate is closer to the sample than the upbeam plate 81.

The electron-optical arrangement 80 may further comprise a spacer 88. The spacer 88 may be annular. In the spacer 88 may be an opening for the passage of all beams of the beam grid. The spacer 88 may be comprised of insulating material such as a dielectric material. The diameter of the opening in the spacer may be dimensioned to avoid the spacer influencing the beams of the beam grid, for example to avoid the spacer causing the beams of the beam grid to vary from their respective paths. The spacer 88 may extend circumferentially in a plane that is substantially parallel to the initial mid-surface (of the upbeam plate 81).

In some embodiments, the upbeam plate 81 is configured to be supported at an edge portion thereof, for example by the spacer 88. The edge portion may be a radially outward portion of the upbeam plate 81. The edge portion may be a radially outward annular portion of the upbeam plate 81. A boundary of the edge portion may be defined by the outer circumference of the upbeam plate 81. The upbeam plate 81 may be supported by the spacer 88. For example, the spacer 88 may support the edge portion of the upbeam plate 81. The edge portion of the upbeam plate may be defined to be a portion of the upbeam plate 81 where the upbeam plate 81 is in physical contact with the spacer 88.

In some embodiments, the downbeam plate 82 is configured to be supported at an edge portion thereof. The edge portion is a radially outward portion of the downbeam plate 82. The edge portion may be a radially outward annular portion of the downbeam plate 82. A boundary of the edge portion may be defined by the outer circumference of the downbeam plate 82. The downbeam plate 82 may be supported by a spacer. The downbeam plate 82 may be supported by the space 88 which supports the upbeam plate 81. The spacer 88 may support the edge portion of the downbeam plate 82. The edge portion of the downbeam plate 82 may be defined to be a portion of the downbeam plate 82 where the downbeam plate 82 is in physical contact with the spacer 88.

The spacer 88 may be interposed between the upbeam plate 81 and the downbeam plate 82. That is, an upbeam surface of the spacer 88 may be in contact with the upbeam plate 81 and a downbeam surface of the spacer 88 may be in contact with the downbeam plate 82, where the upbeam and downbeam surfaces 88 of the spacer 88 may be opposite to one another. Thus, the spacer 88 may inhibit the movement of the edge portion of the upbeam plate 81 in the direction of the downbeam plate 82 (i.e. towards the downbeam plate 82), and the spacer 88 may inhibit the movement of the downbeam plate 82 in the direction of the upbeam plate 81 (i.e. towards the upbeam plate 81). The spacer 88 may be an electric isolator. Thus, the spacer 88 may isolate the upbeam plate 81 from the downbeam plate 82. The spacer may be formed of a dielectric material.

As described above, the upbeam plate 81 and the downbeam plate 82 are arranged such that, when a potential difference is applied between the upbeam plate 81 and the downbeam plate 82, an electric field is present between the upbeam plate 81 and the downbeam plate 82 (and, specifically, between the internal surface of the upbeam plate 81 and the internal surface of the downbeam plate 82). An electric field strength outside of the region between the upbeam plate 81 and the downbeam plate 82 may be much lower than an electric field strength within the region between the upbeam plate 81 and the downbeam plate 82. Thus, a region outside of the region between the upbeam plate 81 and the downbeam plate 82 (e.g. upbeam of the upbeam surface of the upbeam plate 81 and downbeam of the downbeam surface of the downbeam plate 82) may be referred to as a field-free region.

As described above, as a result of the electric field between the facing surfaces of the upbeam plate 81 and the downbeam plate 82, an electrostatic force is exerted on the upbeam plate 81 in the direction of the downbeam plate 82. The electrostatic force exerted on the upbeam plate 81 is a force that may act to deform the upbeam plate 81 (in the absence of other forces acting on the upbeam plate 81). The deformation of the upbeam plate 81 caused by the electrostatic force may comprise electrostatically-induced mechanical distortion of the upbeam plate 81. The deformation of the upbeam plate 81 caused by the electrostatic force may comprise bowing of the upbeam plate 81, for example, bowing of the upbeam plate 81 towards the downbeam plate 82.

The downbeam plate 82 may be deformed in a similar way, but in the opposite direction. That is, deformation of the downbeam plate 82 caused by the electrostatic force exerted on the downbeam plate 82 in the direction of the downbeam plate may cause deformation of the downbeam plate, for example, bowing of the downbeam plate 82 towards the upbeam plate. The deformation of the upbeam plate 81 caused by the electrostatic force applied thereto and/or the deformation of the downbeam plate 82 caused by the electrostatic force applied thereto may result in a distance between a radially inward portion of the upbeam plate 81 (i.e. a portion of the upbeam plate 81 radially inward of the edge portion) and a radially inward portion of the downbeam plate 82 (i.e. a portion of the downbeam plate radially inward of the edge portion) being reduced.

In accordance with an embodiment, the actuator arrangement is configured to apply a force to the upbeam plate 81 to counteract the deformation of the upbeam plate 81 caused by the electrostatic force applied to the upbeam plate 81. The force applied to the upbeam plate 81 by the actuator arrangement may be referred to as a upbeam plate force (or first plate force). The upbeam plate force may be applied by the one or more upbeam plate actuators 85. The one or more upbeam plate actuators 85 may be referred to as one or more first plate actuators. The one or more upbeam plate actuators 85 may be one (a single) upbeam plate actuator 85. Alternatively, the one or more upbeam plate actuators 85 may be a plurality of upbeam plate actuators 85. The one or more upbeam plate actuators 85 may each comprise one or more actuator elements

The actuator arrangement may be further configured to apply a force to the downbeam plate 82 to counteract the deformation of the downbeam plate 82 caused by the electrostatic force applied to the downbeam plate 82. The force applied to the downbeam plate 82 by the actuator arrangement may be referred to as a downbeam plate force (or second plate force). The downbeam plate force may be applied by the one or more downbeam plate actuators 86. The one or more downbeam plate actuators 86 may be referred to as one or more second plate actuators. The one or more downbeam plate actuators 86 may be one (a single) downbeam plate actuator 86. Alternatively, the one or more downbeam plate actuators 86 may be a plurality of downbeam plate actuators 86. The one or more downbeam plate actuators 86 may each comprise one or more actuator elements.

In the following description, the configuration and operation of the actuator arrangement is mainly described in relation to the upbeam plate actuators 85. The configuration and operation of the one or more downbeam plate actuators 86 may be substantially the same as the configuration and operation of the one or more upbeam plate actuators 85, except for the fact that the downbeam plate actuators 86 are configured to apply the downbeam plate force to the downbeam plate 82, rather than to apply the upbeam plate force to the upbeam plate 81.

In some embodiments, the actuator arrangement is configured to apply the upbeam plate force to the upbeam plate 81 to reduce a spatial variance in the distance between each one of the plurality of first apertures at the mid-surface of the upbeam plate 81 and the initial mid-surface of the upbeam plate 81. The distance may be measured along a direction that is perpendicular to the initial mid-surface of the upbeam plate. By reducing the spatial variance in the distance between each one of the plurality of first apertures at the mid-surface of the upbeam plate 81 and the initial mid-surface of the upbeam plate 81, a spatial variance in the distance between each one of the plurality of first apertures and the sample may be reduced. Thus, the magnitude of beam characteristics such as field curvature across the beam grid may be reduced, if not prevented. Consequently, focus of the plurality of probe spots at the planar surface of the sample can be improved.

In some embodiments, the actuator arrangement is configured to apply the upbeam plate force to the upbeam plate 81 to reduce a magnitude of the deformation of the upbeam plate 81. Additionally or alternatively, the actuator arrangement is configured to apply the upbeam plate force to the upbeam plate 81 to modify the shape of the deformation of the upbeam plate 81. The reduction in the magnitude of the deformation of the upbeam plate 81 and/or the modification of the shape of the deformation of the upbeam plate 81 may lead to the reduction in the spatial variance in the distance between each one of the plurality of first apertures at the mid-surface of the upbeam plate 81 and the initial mid-surface (of the upbeam plate 81). Generally, by application of the upbeam plate force, the magnitude and shape of the deformation of the upbeam plate may be controlled, and thus the magnitude of beam characteristics such as field curvature across the beam grid may be controlled. Consequently, focus of the plurality of probe spots at the planar surface of the sample can be controlled.

In some embodiments, the actuator arrangement is configured to apply the upbeam plate force to the upbeam plate 81 to modify (or control) the deformation of the upbeam plate, but not to minimize/reduce the spatial variance in the distance between each one of the plurality of first apertures at the mid-surface of the upbeam plate 81 and the initial mid-surface of the upbeam plate 81. This may be the case where the electron-optical arrangement 80 is, or is part of, a component in which bending of the upbeam plate 81 is desired to achieve a predetermined outcome. For example, this may be the case where the electron-optical arrangement 80 is, or is part of, a curved aperture array, such as a curved collimator array. Such a curved collimator is disclosed and described in EP Application 23211553.5 filed on 22 November 2023 which is hereby incorporated by reference at least so far as the disclosure of a curved lens array comprising curved plates and applications in collimator, for example a plurality of beams for example in a beam grid. In such cases, the actuator arrangement may be configured to apply the force to the upbeam plate 81 to increase the spatial variance in the distance between each one of the plurality of first apertures at the mid-surface of the upbeam plate and the initial mid-surface of the upbeam plate 81, i.e. to increase deformation of the first plate 81, for example by varying its curvature, such as to increase bowing. In some cases (for example, cases where bowing is desired to obtain a desired curvature), the majority of the desired bowing may be provided for by a potential difference between the upbeam plate 81 and the downbeam plate 82, and the upbeam plate actuator arrangement may be configured to apply the upbeam plate force to the upbeam plate 81 to adjust/correct the shape of the deformation of the upbeam plate 81 e.g. to correct bowing of the upbeam plate 81.

As explained above, the configuration and operation of the one or more downbeam plate actuators 86 may be substantially the same as the configuration and operation of the one or more upbeam plate actuators 85. Thus, in some embodiments, the actuator arrangement is configured to apply the downbeam plate force to the downbeam plate 82 to reduce a spatial variance on the distance between each one of the plurality of second apertures at the mid-surface of the downbeam plate 82 and the initial mid-surface of the downbeam plate 82. The actuator arrangement may be configured to apply the downbeam plate force to the downbeam plate 82 to reduce a magnitude of the deformation of the downbeam plate 82 and/or to modify the shape of the deformation of the downbeam plate 82.

The charged particle apparatus 40 or assessment apparatus 100 in which the electron-optical arrangement 80 is disposed may comprise an actuator arrangement controller to control the actuator arrangement. The actuator arrangement controller may be part of the controller 50. Alternatively, the actuator arrangement may be independent of the controller 50. The upbeam actuator arrangement and the downbeam actuator arrangement may be controlled to be actuated together or separately) for example independently) to interact with the electrostatic force applied between the facing surfaces of the upbeam plate 81 and the downbeam plate 82. The one or more upbeam plate actuators 85 may be controlled such that the upbeam plate force exerted by the upbeam plate actuators 85 counteracts the electrostatic force exerted on the upbeam plate 81. The magnitude of the upbeam plate force applied by the upbeam plate actuators 85 may be controlled to reduce the spatial variance in the distances between each of the plurality of first apertures at the mid-surface of the upbeam plate 81 and the initial mid-surface of the upbeam plate 81. In some embodiments, the magnitude of the upbeam plate force applied by the upbeam plate actuators 85 may be controlled to minimize the spatial variance in the distances between each of the plurality of first apertures at the mid-surface of the upbeam plate 81 and the initial mid-surface (of the upbeam plate 81). The one or more downbeam plate actuators may be controlled in substantially the same way.

The magnitude of the upbeam plate force applied to the one or more upbeam plates 81 may be based on the magnitude of the electrostatic force exerted on the upbeam plate 81. That is, the magnitude of the upbeam plate force applied to the upbeam plate 81 may be proportional to the magnitude of the electrostatic force exerted on the upbeam plate 81. The magnitude of the electrostatic force exerted on the upbeam plate 81 is dependent on the magnitude of the potential difference between the upbeam plate 81 and the downbeam plate 82. Thus, the upbeam plate force applied by the upbeam plate actuators may be controlled based on the potential difference between the upbeam plate 81 and the downbeam plate 82. The magnitude of the downbeam plate force applied to the downbeam plate 82 may be controlled in substantially the same way.

In an arrangement, the potential difference between the upbeam plate 81 and the downbeam plate 82 may be dependent on (and determined by) a parameter of the assessment apparatus 100 such as the desired landing energy for the beams of charged particles passing through the electron-optical arrangement 80. Parameters such as the desired landing energy for the beams of charged particles passing through the electron-optical arrangement 80 may be controlled (e.g. set) by the electron-optical arrangement 80. This may particularly be the case where the electron-optical arrangement 80 forms, or forms part of, an objective lens array (e.g. the objective lens array 341). The desired landing energy for the beams of charged particles may vary. Considering this, by virtue of the fact that the magnitude of the upbeam plate force applied to the upbeam plate 81 can be varied (e.g. as a function of the potential difference between the upbeam plate 81 and the downbeam plate 82), deformation of the upbeam plate 81 can be counteracted effectively over a full range of the landing energies for the beams of charged particles.

The actuator arrangement may be configured to apply the upbeam plate force to a peripheral portion of the upbeam plate 81. The peripheral portion of the upbeam plate 81 is the portion of the upbeam plate 81 to which the upbeam plate force is applied. At least some of the peripheral portion of the upbeam plate may be radially inward of the edge portion of the upbeam plate 81. That is, at least some of the peripheral portion to which the upbeam plate force is applied may be radially inward of the portion of the upbeam plate 81 at which the upbeam plate 81 is supported. This may ensure that the application of the upbeam plate force is able to counteract the electrostatic force applied to the upbeam plate 81 as a result of the electric field between the upbeam plate 81 and the downbeam plate 82. Similarly, the actuator arrangement may be configured to apply the downbeam plate force to a peripheral portion of the downbeam plate 82.

The one or more upbeam plate actuators 85 may be physically coupled to the upbeam plate 81 so as to be able to apply the upbeam plate force thereto. For example, the one or more upbeam plate actuators 85 may be disposed on the upbeam surface (i.e. the external surface) of the upbeam plate 81 or the downbeam surface (i.e. the internal surface) of the upbeam plate 81, or both. The same applies for the one or more downbeam plate actuators 86. That is, the one or more downbeam plate actuators 86 may be disposed on the downbeam surface (i.e. the external surface) of the downbeam plate 82, the upbeam (i.e. the internal) surface of the downbeam plate 82, or both. **FIGS. 11 and 12** depict an electron-optical arrangement 80 in which the one or more upbeam plate actuators 85 and the one or more downbeam plate actuators 86 are disposed on external surfaces of the upbeam plate 81 and the downbeam plate 82, respectively. **FIG. 13** depicts an electron-optical arrangement 80 in which the one or more upbeam plate actuators 85 and the one or more downbeam plate actuators 86 are disposed on internal surfaces of the upbeam plate 81 and the downbeam plate 82, respectively.

In some embodiments, such as the embodiments depicted in **FIGS. 11** and **13**, the peripheral portion of the upbeam plate 81 is radially outward of the beam portion 81B of the upbeam plate 81. The beam portion 81B of the upbeam plate 81 may be radially inward of the peripheral portion of the upbeam plate 81. In this context, terms such as radially outward and radially inward are used in relation to (i.e. relative to) the center of the beam grid.

The beam portion 81B of the upbeam plate 81 may be spaced apart from the peripheral portion of the upbeam plate 81. That is, there may be a distance between a radially inner edge of the peripheral portion and a radially outer edge of the beam portion 81B. The radially inner edge of the peripheral portion may be spaced apart from the radially outer edge of the beam portion 81B to ensure that the presence of the upbeam plate actuators 85 does not interfere with the operation of the electron-optical arrangement 80 on the beams of charged particles. This may be of particular importance when the one or more upbeam plate actuators 81 are disposed inside of the electric field that is present between the upbeam plate 81 and the downbeam plate 82 when a potential difference is applied between the upbeam plate 81 and the downbeam plate 82.

In some cases, the presence of the upbeam plate actuators 85 disposed inside of the electric field that is present between the upbeam plate 81 and the downbeam plate 82 may interfere with the operation of the electron-optical arrangement 80 on the beams of charged particles as follows. The one or more upbeam plate actuators 85 may comprise a body formed of an insulative material (e.g. a dielectric body). The dielectric body of the upbeam plate actuators 85 may become charged by the beam of charged particles. The presence of a charged body between the upbeam plate 81 and the downbeam plate 82 could impact the electric field between the upbeam plate 81 and the downbeam plate 82, which may adversely affect the manner in which the electron-optical arrangement 80 operates on the one or more beams (e.g. for the case that the electron-optical arrangement is a positive lens arrangement, the presence of the charged body may adversely affect the focusing of the one or more beams). Further, the presence of a charged body within the region between the upbeam plate 81 and the downbeam plate 82 may present a risk of discharge. By spacing apart the peripheral portion from the beam portion 81B, the extent to which the upbeam plate actuators 85 become charged and/or the extent to which a charged body of the upbeam plate actuators are able to affect the operation on the one or beams is reduced. Additionally, the risk of discharge is reduced.

In other words, where the upbeam plate actuators 85 comprise a body formed of a dielectric (or otherwise insulative) material and are disposed in a region between the upbeam plate 81 and the downbeam plate 82, it may be desirable for the one or more upbeam plate actuators 85 to be spaced apart from the one or more first apertures in the beam portion 81B of the upbeam plate 81. The spacing between the one more upbeam plate actuators 85 (and, particularly, the dielectric material of the one or more upbeam plate actuators 85) and the beam portion 81B (and, particularly, the path of the beams of the beam grid) may reduce the impact of the presence of the dielectric body of the upbeam plate actuators 85 on the electric field between the upbeam plate 81 and the downbeam plate 82 in the region surrounding the one or more beams for example in influencing the beams such as inducting a disturbance in the electron-optical characteristics of one more of the beams and/or risking unwanted discharge. As such, the extent to which the presence of the upbeam plate actuators 85 adversely affects the operation of the electron-optical arrangement 80 on the one or more beams is reduced.

The distance between the one or more upbeam plate actuators 85 and the beam portion 81B ($d_2$) may be dependent on a height of the one or more upbeam plate actuators ($d_1$). The desirable separation between the one or more upbeam plate actuators 85 and the beam portion 81B may be proportional to the height of the one or more upbeam plate actuators 85. For example, a minimum distance (in a direction substantially parallel to the initial mid-surface of the upbeam plate 81) between any of the one or more first apertures and any of the one or more upbeam plate actuators 85 may be greater than a height of the upbeam plate actuators 85, for example greater than a dimension that is a multiple of the height of the upbeam plate actuators 85.

The one or more downbeam plate actuators 86 may be spaced apart from the beam portion 82B of the downbeam plate 82 in the same way as the upbeam plate actuators 85 are spaced apart from the beam portion 81B of the upbeam plate 81.

In some embodiments, the one or more upbeam plate actuators 85 are disposed outside of the electric field that is present between the upbeam plate 81 and the downbeam plate 82 when a potential difference is applied between the upbeam plate 81 and downbeam plate 82, for example between the facing surfaces of the two plates 81, 82. That is, the one or more upbeam plate actuators 85 may be disposed in a field-free region. For example, the one or more upbeam plate actuators 85 may be disposed on the upbeam surface of the upbeam plate 81. Such a configuration is depicted in **FIGS. 11 and 12**. By providing the one or more first plate actuators 85 outside of the electric field that is present between the upbeam plate 81 and the downbeam plate 82 (i.e. in a field-free region), the occurrence of the one or more first plate actuators 85 interfering with the paths of the beams (as described above) can be avoided or otherwise reduced, and a risk of undesired discharge can be reduced. In the same way, the one or more downbeam plate actuators 86 may be disposed outside of the electric field that is present between the upbeam plate 81 and the downbeam plate 82. To be disposed outside of the electric field that is present between the upbeam plate 81 and the downbeam plate 82 in the electron-optical arrangement 80, the one or more downbeam plate actuators 86 may be disposed on the downbeam surface of the downbeam plate 82.

In some embodiments, such as the embodiment depicted in **FIG. 12,** the peripheral portion of the upbeam plate 81 (i.e. the portion of the upbeam plate 81 on which the upbeam plate actuators 85 act) may extend up to and through the beam portion 81B of the upbeam plate 81. However, in this case, the one or more upbeam plate actuators 85 do not block the one or more first apertures in the beam portion 81B. The one more first apertures may be defined in (for example extend through) the one or more upbeam plate actuators 85, for example, the one or more first apertures may extend through planar bodies of the one or more upbeam plate actuators 85. In an arrangement, the one or more upbeam plate actuators 85 may extend through the beam portion 81B of the upbeam plate but around the one or more first apertures, so as not to impede the passage of the beams of charged particles through the upbeam plate 81. When the peripheral portion of the upbeam plate 81 extends up to and through the beam portion 81B, it may be desirable for the one or more upbeam plate actuators 85 to be disposed outside of the electric field between the facing surfaces of the on the upbeam surface of the upbeam plate. The peripheral portion of the downbeam plate 82 (i.e. the portion of the downbeam plate 82 on which the downbeam plate actuators 86 act) may extend up to and through the beam portion 82B of the downbeam plate 82.

In an arrangement, and as depicted for the embodiments of **FIGs 11 to 13**, the actuator arrangement comprises the one or more upbeam plate actuators 85 and the one or more downbeam plate actuators 86. That is, the actuator arrangement comprises the upbeam actuator arrangement and the downbeam actuator arrangement. However, in other embodiments, the electron-optical arrangement 80 comprises one (for example, only one) of the upbeam plate actuator arrangement and the downbeam actuator arrangement.

Desirably, the actuator arrangement may be configured to apply the upbeam plate force to the upbeam plate 81 and the downbeam plate force to the downbeam plate 82. If the actuator arrangement is configured to apply a force to only one of the upbeam plate 81 and the downbeam plate 82, it may be preferable for the actuator arrangement to apply a force to the plate which is located at a position corresponding to the lowest beam energy of the beams in the beam grid. In other words, it may be preferable for the actuator arrangement to apply a force to the plate which is at the smallest magnitude of potential relative to the ground. This may be because a change in the position of apertures defined in a plate which is located at a position corresponding to a lower beam energy may lead to a larger impact on the operation performed on the beams of the beam grid, as compared to a change in the position of apertures defined in a plate which is located at a position corresponding to a higher beam energy. This applies in the same way for electron-optical arrangements comprising more than two plates.

In some embodiments, the upbeam actuator arrangement may comprise at least two actuators (or there may be at least two upbeam plate actuators), with a upbeam plate actuator disposed on the internal surface of the upbeam plate actuator 85 disposed on the external surface of the upbeam plate 81. In other embodiments, the one or more upbeam plate actuators 85 may be disposed on the internal surface of the upbeam plate 81 and the one or more downbeam plate actuators 86 may disposed on the internal surface of the downbeam plate 82. In some embodiments, the one or more upbeam plate actuators 85 may be disposed on the external surface of the upbeam plate 81 and the one or more downbeam plate actuators 86 may disposed on the internal surface of the downbeam plate 82. In some embodiments, the one or more upbeam plate actuators 85 may be disposed on the internal surface of the upbeam plate 81 and the one or more downbeam plate actuators 86 may disposed on the external surface of the downbeam plate 82. The downbeam actuator arrangment may be configured in the same way.

In embodiments where the upbeam plate actuators 85 comprise a body formed of a dielectric material and are disposed in a region between the upbeam plate 81 and the downbeam plate 82, the one or more upbeam plate actuators may be electrostatically shielded. For example, the one or more upbeam plate actuators 85 may be provided with a conductive coating. This may allow the upbeam plate actuators 85 to be disposed closer to the beam portion 81B of the upbeam plate 81. In embodiments where the downbeam plate actuators 86 comprise a body formed of a dielectric material and are disposed in a region between the upbeam plate 81 and the downbeam plate 82, the one or more downbeam plate actuators 86 may be electrostatically shielded. For example, the one or more downbeam plate actuators 86 may be provided with a conductive coating. This may allow the downbeam plate actuators 86 to be disposed closer to the beam portion 82B of the downbeam plate 82.

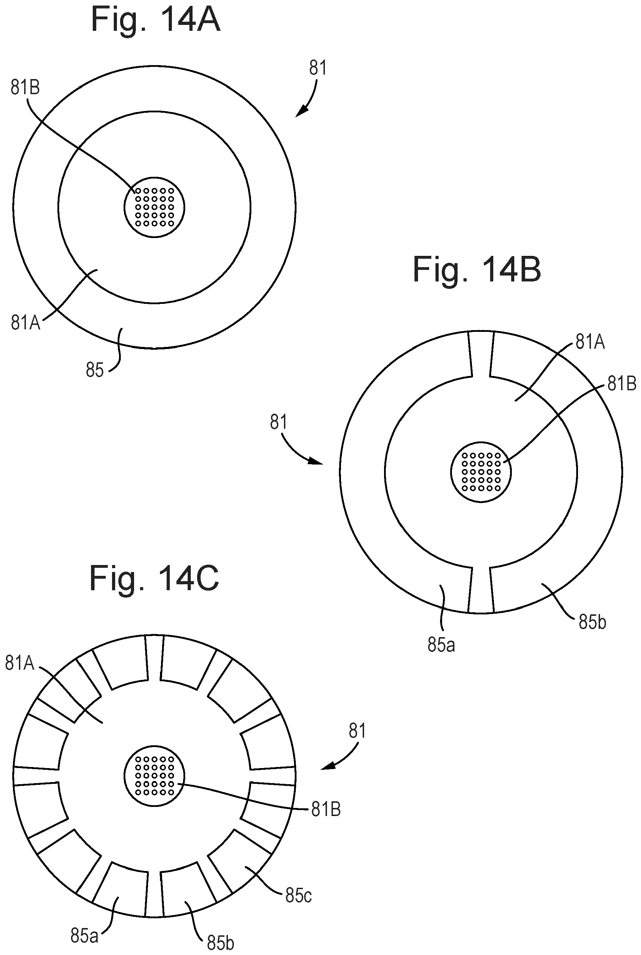

FIGS. 14A-14C depict different arrangements of the upbeam plate actuators 85 on the upbeam plate 81. Although the apertures are shown in an aperture array with a square grid, the arrangement of the apertures in the aperture array may have any selected pattern. The arrangements depicted in FIGS. 14A-14C may apply for the case that the actuator arrangement of one or more upbeam plate actuators 85 has one or more actuators disposed on the upbeam (i.e. external) surface of the upbeam plate 81, one or more actuators disposed on the downbeam (i.e. internal) surface of the upbeam plate 81, or both. The arrangements depicted in FIGS. 14A-14C show a view of the upbeam or downbeam surface of the upbeam plate 81. Although the arrangements are shown and described with reference to the arrangement of actuators of the one or more upbeam plate actuators 85 and the upbeam plate 81, the description may relate to the arrangement of actuators of the one or more downbeam plate actuators 86 and the downbeam plate 82.

In some embodiments, the actuator arrangement comprises a plurality of upbeam plate actuators 85 distributed around the peripheral portion of the upbeam plate. FIG. 14B depicts a configuration in which the actuator arrangement comprises two upbeam plate actuators 85a, 85b. FIG. 14C depicts a configuration in which the actuator arrangement comprises twelve upbeam plate actuators 85a, 85b, 85c, ... 85l. The plurality of upbeam plate actuators 85a, 85b, 85c may be distributed peripherally e.g. in the circumferential (or azimuthal) direction, around the peripheral portion of the upbeam plate 81. In some embodiments, the plurality of upbeam plate actuators 85a, 85b, 85c may be distributed uniformly around the peripheral portion. The arrangement of the upbeam plate actuators 85a, 85b, 85c may be rotationally symmetrical around the beam portion 81B of the upbeam plate 81.

Each individual upbeam plate actuator 85a, 85b, 85c may be annular. The upbeam plate actuators 85a, 85b, 85c may be positioned radially, for example with respect to each other, for example in a radial direction. This may be such that the plurality of upbeam plate actuators 85a, 85b, 85c are arranged as a plurality of concentric annuli e.g. rings. The upbeam plate actuators 85a, 85b, 85c may be positioned to have a radial distribution. The radial distribution of the upbeam plate actuators may be substantially uniform.

The plurality of upbeam plate actuators 85a, 85b, 85c may be arrayed in an azimuthal direction (for example a circumferential direction with respect to a midpoint of the beam area 81B such as the path of the beam grid) and a radial direction (for example with respect to a midpoint of the beam area 81B such as the path of the beam grid). In such an actuator arrangement, the upbeam plate actuators 85a, 85b, 85c forms a grid distributed over the upbeam plate 81.

The different upbeam plate actuators 85 (for example, of the upbeam actuator arrangement) may be independently controllable. That is, the force applied to the upbeam plate 81 by each one of the upbeam plate actuators 85 may be independent of the force applied to the upbeam plate 81 by the other upbeam plate actuators 85. For example, the force applied to the upbeam plate 81 by one of the upbeam plate actuators 85a may be different to the force applied to the upbeam plate 81 by another of the upbeam plate actuators 85b, 85c, etc.. By providing independently controllable upbeam plate actuators 85, the deformation of the upbeam plate can be controlled, for example more precisely. For example, more precise modifications of the shape of the upbeam plate 81 may be performed as compared to the case where the upbeam plate actuators 85 are controlled together (i.e. not independently). Through more precise modification of the shape of the upbeam plate 81, spatial variance in the distances between each of the plurality of first apertures at the mid-surface of the upbeam plate 81 and the initial mid-surface of the upbeam plate 81 may be reduced more effectively (for example as compared to the case where the upbeam plate actuators 85 are controlled together (i.e. not independently)). The different downbeam plate actuators 86 (for example, of the downbeam actuator arrangement) may be independently controllable in the same way.

In an upbeam plate actuator arrangement, the number of upbeam plate actuators 85 and/or the number of downbeam plate actuators 86 may be equal to or greater than 2, optionally equal to or greater than 5, further optionally equal to or greater than 10. The number of upbeam plate actuators 85 and/or the number of downbeam plate actuators 86 are less than 1000, and optionally less than 100. In an embodiment, the number of upbeam plate actuators 85 and/or the number of downbeam plate actuators 86 is 2. In an embodiment, the number of upbeam plate actuators 85 and/or the number of downbeam plate actuators 86 is 4. In an embodiment, the number of upbeam plate actuators 85 and/or the number of downbeam plate actuators 86 is 8. Increasing the number of upbeam plate actuators 85 provides greater control over the force that is applied to the upbeam plate 81, and so spatial variance in the distances between each of the plurality of first apertures at the mid-surface of the upbeam plate 81 and the initial mid-surface of the upbeam plate 81 can be reduced to a greater degree. Increasing the number of downbeam plate actuators 86 provides greater control over the force that is applied to the downbeam plate 82, and so spatial variance in the distances between each of the plurality of second apertures at the mid-surface of the downbeam plate 82 and the initial mid-surface of the downbeam plate 82 can be reduced to a greater degree. However, increasing the number of upbeam plate actuators and/or the number of downbeam plate actuators 86 excessively results in an unnecessary increase in the complexity of the electron-optical arrangement 80. For every additional actuator there may be an additional electrical connection required for the plate as herein later related. Each additional electrical connection may be undesirable for use in an electron-optical column operating on beams for which disturbances such as stray fields generated by electrical connections and power lines are undesirable or even unwanted.

In some embodiments, the upbeam actuator arrangement comprises a single upbeam plate actuator 85 extending around the peripheral portion of the upbeam plate 81. The single upbeam plate actuator 85 may extend circumferentially around the peripheral portion of the upbeam plate 81. In some embodiments, the upbeam plate actuator 85 extends around substantially all of the circumference of the peripheral portion (e.g. greater than 75%, optionally greater than 95% and further optionally greater than 98% of the circumference of the peripheral portion). Such a configuration is depicted in **FIG. 14A**. Similarly, the downbeam actuator arrangement may comprise a single downbeam plate actuator 86 extending around the peripheral portion of the downbeam plate 86.

The upbeam actuator arrangement and/or the downbeam actuator arrangement may comprise any actuator suitable to perform the functionality described above. Such an actuator may be a piezoelectric. The actuator may have a dimension in the direction of the beam path (i.e. a thickness) of less than 100 $\mu$m, optionally less than less than 50 $\mu$m and further optionally less than 20 $\mu$m. A piezoelectric actuator with such a thickness may be able to apply a upbeam plate force with sufficient magnitude to counteract effectively the electrostatic force exerted on the upbeam plate. The piezoelectric actuator may be configured so as to be able to apply a force on the plates in an upbeam direction and a downbeam direction.

The piezoelectric actuator may be configured to actuate on the application of a voltage thereto. Where the upbeam plate actuator arrangement has one or more actuators that are piezoelectric actuators, the magnitude of the upbeam plate force may be controlled by controlling the voltage supplied to the upbeam plate actuators 85 for applying to the piezoelectric actuators, i.e. by controlling the potential difference between electrodes of the piezoelectric actuator. The assessment apparatus, within which the electron-optical arrangement 80 is disposed, may comprise an actuator power source configured to apply the potential difference to the piezoelectric actuators. The actuator arrangement may comprise at least one electrical connection for each plate 81, 82. The actuator arrangement may comprise an electrical connection for each upbeam plate actuator 85. Each of the piezoelectric actuators may comprise an actuator electrode electrically connected to the electrical connection. In the case that there is only a single upbeam plate actuator 85, the actuator arrangement may comprise a single electrical connection for the upbeam plate 81. The actuator arrangement may comprise a single electrode for the upbeam plate 81. It may be desirable for the number of electrical connections not to be larger than is necessary. Thus, it may be desirable for the number of the upbeam plate actuators 85 not to be larger than necessary (e.g. less than 1,000 and optionally less than 100, desirably less than 10, as discussed above). For maximum simplicity the number of upbeam plate actuators may be just one). In an arrangement it may be desirable to have optimum simplicity, for example, by there being no more than an extra ten electrical connections for the actuators present on a plate, (the main connection being to apply a potential to the plate), desirably no more than an additional five electrical connections, desirably no more than an additional four electrical connections, desirably not more than an additional three electrical connections, and optimally no more than an additional one electrical connection. In general, a larger number of actuators results in increased control and a lower number of actuators results in increased simplicity

In some embodiments, the upbeam actuator arrangement may comprise a bimetallic actuator. Thus the one or more upbeam plate actuators 85 comprise one or more bimetallic actuators. The upbeam plate force applied to the upbeam plate 81 by a bimetallic actuator may be controlled by controlling the temperature of the bimetallic actuator. Such a bimetallic actuator may comprise conductive material. The bimetallic actuator may comprise material which is not insulating, i.e. which is not a dielectric material. The bimetallic actuator has a body which does not comprise dielectric material. The bimetallic actuators need not electrostatic shielding. Considerations relating to the distance between the upbeam plate actuators 85 and/or the downbeam plate actuators 86 and the beam portions 81B, 82B may not apply for use of a bimetallic actuator in the upbeam actuator arrangements. Bimetallic actuators may be used in the case that the upbeam plate actuators 85 extend up to and through the beam portion 81B of the upbeam plate 81, as depicted in **FIG. 12.**

In some embodiments, the one or more of the upbeam plate actuators 85 comprise one or more electrostatic actuators. Each of the electrostatic actuators may comprise an electrode.

As discussed above, the downbeam plate actuators 86 may possess the same features as the upbeam plate actuators 85, and be arranged in a corresponding manner. However where the actuators of the upbeam actuator arrangement are located on an upbeam or downbeam surface of the upbeam plate 81 in view of the presence of electric field or field free region present (such as an electric field present a region between the downbeam plate and the upbeam plate and a field free region the other side of the plates), such considerations are applied for locating the position of the actuators of the downbeam actuator arrangement with respect to the downbeam plate 82.

In an arrangement, an insulating member may be provided between the upbeam plate 81 and the one or more upbeam plate actuators 85 to isolate the one or more upbeam plate actuators 85 from the upbeam plate 81.

The electron-optical arrangement 80 may comprise a strain gauge (not shown). The strain gauge may be configured to measure the magnitude of deformation of the upbeam plate 81 and/or the downbeam plate 82. The strain gauge may indirectly measure the deformation of the upbeam plate 81 by measuring the deformation of one or more upbeam plate actuator 85. In such an embodiment, the strain gauge may be attached to the one or more upbeam plate actuators 85. The control of the one or more upbeam plate actuators 85 may be based on the deformation of the upbeam plate as measured by the strain gauge. Together the strain gauge, the actuator arrangement controller and the one or more upbeam plate actuators 85 may form a closed loop control system.

The upbeam plate 81 and/or the downbeam plate 82 are formed from a material comprising silicon. For example, the upbeam plate 81 and/or the downbeam plate 82 may be formed from a material substantially comprising silicon, or from a material consisting essentially of silicon. The silicon may comprise monocrystalline silicon. A thickness of the upbeam plate 81 and/or a thickness of the downbeam plate 82 (i.e. a dimension of the upbeam plate and/or the downbeam plate for example in a direction of the path of the beam grid and/or in a direction substantially parallel to the initial mid-surfaces thereof) may be less than or equal to 300 $\mu$m, optionally less than or equal to 200 $\mu$m, and further optionally less than or equal to 150 $\mu$m. Providing plates with a small thickness may allow the module in which the electron-optical arrangement is provided to be made smaller and/or for more components (e.g. other plates) to be included in the module in which the electron-optical arrangement is provided. However, as described above, reducing a thickness of the plates 81, 82 may enable the distortion of the plates 81, 82 to become more severe. Thus, by providing the actuator arrangement of the present disclosure and countering the deformation of the plates 81, 82, the thickness of the plates 81, 82 may be reduced without negatively impacting an electron-optical parameter of the beams for example the focus of the charged particle beams at the probe spots.

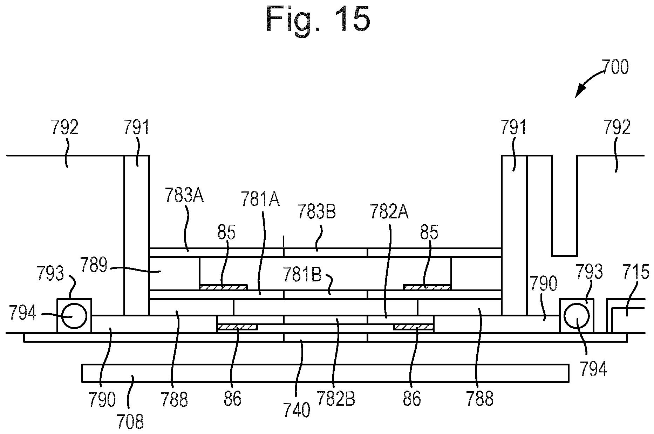

**FIG. 15** depicts a portion of module 700 of a charged particle optical device for projecting a multibeam of charged particles toward a sample 708. The module 700 is one example of how the electron-optical arrangement 80 of the present disclosure may be implemented within a wider syste,. The module may incorporate an electron-optical component having the electron-optical arrangement 80 shown and described with reference to **FIGs 11 to 14C.** The module may be part of a charged particle-optical device such as the charged particle-optical device 40. The charged particle-optical device comprises a sample support to support a sample 708. The sample support may comprise a motorized or actuated stage and/or take any of the forms described above with reference to **FIG. 1** and/or **FIG. 2.** The charged particle optical device is a charged particle-optical device configured to project a plurality of beams of a multibeam of the charged particles along a plurality of paths toward the sample 708 (for example, as primary beams in a beam grid along the path of the beam grid). The module 700 may define a lens arrangement such as an objective lens arrangement comprising an objective lens array and optionally a control lens array. The lens arrangement may comprise a plurality of plates in which a plurality of apertures are defined in the different plates positioned along the beam paths of the beam grid. The lens arrays of the objective lens arrangement may respectively comprise a structure corresponding to the electron-optical arrangement 80.

The module 700 comprises one or more electron-optical arrangements. The electron-optical arrangements may each be similar to the electron-optical arrangements 80 described above and depicted in **FIGS. 10 to 14C**. Although there may be several electron-optical arrangements that embody the electron-optical arrangement 80, the following description refers to one such electron-optical arrangement as an exemplary embodiment of the electron-optical arrangement 80. The electron-optical arrangement 80 described hereabove may be embodied by any two adjoining electrode plates in which one or more apertures are defined for the passage of one more charged particle beams, where the electrode plates are separated and supported by a spacer that may be electrically insulating.

The electron-optical arrangement may comprise a upbeam plate 781 (equivalent to the upbeam plate 81 of the electron-optical arrangement 80) and a downbeam plate 782 (equivalent to the downbeam plate 82 of the electron-optical arrangement 80). The electron-optical arrangement further comprises one or more upbeam plate actuators 785 configured to apply a upbeam plate force to the upbeam plate 781, and one or more downbeam plate actuators configured to apply a downbeam plate force on the downbeam plate 782. As described above, the upbeam plate 781 and the downbeam plate 782 are electrodes. A first spacer 788 (equivalent to the spacer 88 of the electron-optical element 80) is disposed between the upbeam plate 781 and the downbeam plate 782.

The module 700 further comprises a further plate 783 (or the third plate). The further plate 783 may be an electrode. The further plate 783 may be similar in structure to the upbeam plate 781 and the downbeam plate 782. The further plate 783 may be upbeam of the upbeam plate 781. A further spacer 789 (or a second spacer) may be interposed between the upbeam plate 781 and the 783. The module 700 may comprise one or more further plates (not shown) upbeam of the further plate 783. For example, the module 700 may comprise an additional plate (or the fourth plate - not shown) upbeam of the further plate 783. An additional spacer, or third spacer (not shown) may be interposed between the further plate 783 and the additional plate. The further plate 783 and the additional plate may form part of a control lens array 350. The further plate 783 and the additional plate may form electron-optical arrangement similar to the electron-optical arrangement 80 described above and depicted in **FIGS. 10 to 14C**. That is, the electron-optical arrangement formed by the further plate 783 and the additional plate may comprise an actuator arrangement in a similar to manner to the actuator arrangement of the electron-optical arrangement 80.

The further spacer 789 may be interposed between the objective lens arrangement (formed of the upbeam plate 781 and the downbeam plate 782) and the control lens arrangement (formed of at least two plates such as the further plate 783 and the additional plate). That is, the spacer 798 may be interposed between plates 781, 783 of different electron-optical arrangements which may take the function of respective electron-optical components.

Implementation of the electron-optical arrangement 80 of the present disclosure in an objective lens array, for example, as depicted in **FIG. 15,** may be accompanied by use of a finger print corrector configured to control a field curvature fingerprint. For example, the actuator arrangement of the electron-optical arrangement 80 may be configured to apply the first plate force and/or the second plate force to deform the first plate and/or the second plate such that the operation of the electron-optical arrangement 80 on the plurality of beams of the beam grid has a desired effect on field curvature. For example, the actuator arrangement of the electron-optical arrangement 80 may be configured to apply the first plate force and/or the second plate force to deform the first plate and/or the second plate such that the operation of the electron-optical arrangement 80 on the plurality of beams of the beam grid counteracts sources of field curvature introduced at different parts of the charged particle-optical device 40. Details of such an arrangement is described in EP Application Number 23217694.1 filed 18 December 2023 which, with respect to how the finger print corrector is implemented in the objective lens is incorporated is hereby incorporated by reference.

Different arrangements of modules, having some of the same features as module 700, may, comprise electron optical components such as a condenser lens array (e.g. the condenser lens 231) and/or a collimator array (e.g. the collimator array 271 for example as a deflector array or lens array) and/or a multipole array, and/or a corrector and/or a deflector such as a deflector array (e.g. scan deflector array or collimator defector array) and/or a separator array (e.g. a Wien filter array). The actuator arrangement described in relation to the electron-optical arrangement 80 may be applied to any electron-optical component comprising two or more plates with apertures therein. For example, the actuator arrangement may be applied to a condenser lens array (e.g. the condenser lens 231), a collimator array (e.g. the collimator array 271) or scan deflector array (e.g. the scan deflector array 360). In an arrangement the module 700 may additionally comprise such electron components such as at least one of the collimator array, deflector array, corrector array, and/or the separator array; such electron-optical components may be alternative in the module to the detector array and one or more lens arrays for example should the module be at intermediate location of the charged particle device i.e spaced away from a sample so that a different module may be proximate the sample. In an arrangement, such a module may comprise the source converter 220 such as shown and described with reference to **FIG 2** in which the different electron-optical components take the form of one more arrangements taking the structure of the electron-optical arrangement 80.

The module 700 further comprises a detector array 740. The detector array 740 may be planar, or substantially planar. The detector array 740 may have a similar structure to the detector array 340 described above and depicted in **FIG. 6.** The module 700 may comprise an additional spacer interposed between the detector array 740 and an adjoining electron-optical component which may take the form of the electron-optical arrangement 80. For example, the additional spacer may be disposed between the detector array 740 and an adjoining electron-optical component at a periphery of the detector array 740. In the embodiment depicted in **FIG. 15,** the adjoining electron-optical component is the objective lens arrangement (for example, comprising at least the objective lens array and optionally the control lens array) that is formed of the upbeam plate 781 and the downbeam plate 782. That is, the additional spacer is interposed between the detector array 740 and the objective lens array (formed of the upbeam plate 781 and the downbeam plate 782). Note in an arrangement the objective lens array, for example as an objective lens arrangement, may comprise the detector array. Specifically, the additional spacer is interposed between an external surface of the downbeam plate 782 and the detector array 740. In some embodiments, the detector array 740 may be supported on a detector substrate, and the additional spacer is interposed between the downbeam plate 782 and the detector substrate.

Each of the plurality of beams may pass through an aperture in a first beam portion 783B of the further plate 783, an aperture in a beam portion 781B of the upbeam plate 781, an aperture in a beam portion 782B of the downbeam plate 782, and an aperture in the detector 740. In the orientation shown in **FIG. 15,** the primary beams may have a direction corresponding to the path of the beam grid through the charged particle-optical device towards the sample, for example along the path from source to sample position. In the depicted orientation of the module 700, the primary beams may be in a downbeam direction . The orientation of the module 700 is any orientation which may be desirably selected.

In an embodiment the charged particle-optical module 700 is field replaceable. The charged particle-optical module 700 may be removed from and/or inserted into the charged particle-optical device 40 without requiring any substantial dismantling of other parts of the charged particle-optical device 40. That is the charged particle-optical module 700 may be removable from and/or insertable into the charged particle-optical device.

References to upper and lower, up and down, above and below, etc. should be understood as referring to directions parallel to the (typically but not always vertical) upbeam and downbeam directions of charged particle beams impinging on the sample 208. Thus, references to upbeam and downbeam are intended to refer to directions in respect of the beam path independently of any present gravitational field.

As used herein, the use of ordinal numbers (i.e. first, second, third etc.) is to provide distinct labels for different features and components such that they can be referred to easily. The ordinal number assigned to a component or feature is not intended to imply any structural or functional attributes of the component or feature. For instance, where first, second and third plates are provided within an electron-optical device, the order of the plates in the downbeam direction is not necessarily the first plate followed by the second plate followed by the third plate.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:

Clause 1. An charged particle-optical arrangement for a charged particle beam apparatus configured to operate on at least one beam of charged particles, the charged particle-optical arrangement comprising: a first plate which defines at least one first aperture for passage of the at least one beam therethrough; and a second plate which defines at least one second aperture for passage of the at least one beam therethrough; and an actuator arrangement configured to apply a force to the first plate.

Clause 2. The charged particle-optical arrangement of clause 1, wherein the first plate and the second plate are arranged such that, when a potential difference is applied between the first plate and the second plate, an electrostatic force is exerted on the first plate in the direction of the second plate, and the actuator arrangement is configured to apply the force to the first plate to counteract a deformation of the first plate caused by the electrostatic force applied to the first plate.

Clause 3. The charged particle-optical arrangement of clause 2, wherein the actuator arrangement is configured to apply the force to the first plate to reduce a magnitude of the deformation of the first plate.

Clause 4. The charged particle-optical arrangement of clause 2 or 3, wherein the actuator arrangement is configured to apply the force to the first plate to modify the shape of the deformation of the first plate.

Clause 5. The charged particle-optical arrangement of any of clauses 1 to 4, wherein the charged particle-optical arrangement is adapted to be used in a multibeam apparatus configured to operate on a plurality of beams of charged particles, optionally wherein the plurality of beams of charged particles are in a beam grid.

Clause 6. The charged particle-optical arrangement of clause 5, wherein the first aperture is configured to permit passage of the plurality of beams therethrough, and the second aperture is configured to permit passage of the plurality of beams therethrough.

Clause 7. The charged particle-optical arrangement of clause 5, wherein: the first plate defines a plurality of first apertures, wherein each one of the plurality of first apertures is for the passage of one or more of the plurality of beams through the first plate; and the second plate defines a plurality of second apertures, wherein each one of the plurality of second apertures is for the passage of one or more of the plurality of beams through the second plate.

Clause 8. The charged particle-optical arrangement of clause 7, wherein: when the first plate is undeformed, the first plate is substantially planar; a first mid-surface is a mid-surface of the first plate when the first plate is undeformed; and the actuator arrangement is configured to apply the force to the first plate to reduce a spatial variance in the distance between each one of the plurality of first apertures and the first mid-surface.

Clause 9. The charged particle-optical arrangement of any of clauses 2 to 8, wherein the deformation of the first plate caused by the electrostatic force comprises electrostatically-induced mechanical distortion of the first plate, optionally wherein the deformation of the first plate caused by the electrostatic force comprises bowing of the first plate, optionally wherein the deformation of the first plate caused by the electrostatic force results in a distance between a radially inward portion of the first plate and a radially inward portion of the second plate being reduced.

Clause 10. The charged particle-optical arrangement of any of the preceding clauses, wherein the first plate is configured to be supported at an edge portion thereof, optionally wherein the charged particle-optical arrangement further comprises a spacer, further optionally wherein the spacer is configured to support the edge portion of the first plate, further optionally wherein the spacer is further configured to support an edge portion of the second plate, further optionally wherein the spacer is interposed between the first plate and the second plate, and further optionally wherein the spacer is an electric isolator.

Clause 11. The charged particle-optical arrangement of clause 10, wherein the actuator arrangement is configured to apply the force to a peripheral portion of the first plate, optionally wherein at least some of the peripheral portion of the first plate is inward of the edge portion of the first plate.

Clause 12. The charged particle-optical arrangement of clause 11, wherein the one or more first apertures are defined in an inner portion of the first plate and the one or more second apertures are defined in an inner portion of the second plate, wherein the inner portion is inward of the peripheral portion, and optionally wherein the inner portion of the first plate and the inner portion of the second plate are central portions.

Clause 13. The charged particle-optical arrangement of any of the preceding clauses, wherein the force applied to the first plate by the actuator arrangement is a first plate force, and the actuator arrangement comprises one or more first plate actuators configured to apply the first plate force to the first plate.

Clause 14. The charged particle-optical arrangement of clause 13, wherein the one or more first plate actuators are controllable such that the magnitude of the first plate force can be varied.

Clause 15. The charged particle-optical arrangement of clause 13 or 14, wherein the one or more first plate actuators are disposed outside of an electric field between the first plate and the second plate, desirably wherein the electric field is created by a potential difference is applied between the first and second plate.

Clause 16. The charged particle-optical arrangement of any of clauses 13 to 15, wherein the first plate comprises an internal surface and an external surface, wherein the internal surface of the first plate faces the second plate, and the one or more first plate actuators are disposed on the external surface of the first plate.

Clause 17. The charged particle-optical arrangement of any of clauses 13 to 16, wherein the actuator arrangement comprises a plurality of first plate actuators distributed around the peripheral portion of the first plate, optionally wherein the plurality of first plate actuators are distributed circumferentially around the peripheral portion of the first plate.

Clause 18. The charged particle-optical arrangement of clause 17, wherein the number of first plate actuators is equal to or greater than 2, optionally equal to or greater than 5, further optionally equal to or greater than 10, and less than 100.

Clause 19. The charged particle-optical arrangement of clause 17 or 18, wherein each of the plurality of first plate actuators are independently controllable.

Clause 20. The charged particle-optical arrangement of any of clauses 13 to 16, wherein the actuator arrangement comprises a single first plate actuator extending around the peripheral portion of the first plate, optionally wherein the single first plate actuator extends circumferentially around the peripheral portion of the first plate.

Clause 21. The charged particle-optical arrangement of any of clauses 13 to 20, wherein the one or more first plate actuators comprise one or more piezoelectric actuators.

Clause 22. The charged particle-optical arrangement of clause 21, wherein a thickness of the one or more piezoelectric actuators is less than 100 $\mu$m, optionally less than 50 $\mu$m and further optionally less than 20 $\mu$m.

Clause 23. The charged particle-optical arrangement of any of clauses 13 to 20, wherein the one or more first plate actuators comprise one or more bimetallic actuators.

Clause 24. The charged particle-optical arrangement of any of clauses 13 to 20, wherein the one or more of the first plate actuators comprise one or more electrostatic actuators.

Clause 25. The charged particle-optical arrangement of any of clauses 13 to 24, wherein the one or more first plate actuators comprise an electrode.

Clause 26. The charged particle-optical arrangement of any of clauses 8 to 20, wherein the actuator arrangement further comprises one or more second plate actuators configured to apply a second plate force to the second plate.

Clause 27. The charged particle-optical arrangement of any of the preceding clauses, wherein the actuator arrangement comprises at least one electrical connection for each plate, the electrical connection configured to supply power to the actuator arrangement, optionally wherein the actuator arrangement comprises one electrical connection for each actuator, further optionally wherein the actuator arrangement comprises only one electrical connection for each plate.

Clause 28. The charged particle-optical arrangement of any of the preceding clauses, wherein the actuator arrangement is electrostatically shielded.

Clause 29. The charged particle-optical arrangement of clause 28, wherein a first shielding layer is provided around the one or more first plate actuators and/or a second shielding layer is provided around the one or more second plate actuators.

Clause 30. The charged particle-optical arrangement of any of clauses 1 to 27, wherein (i) a minimum distance between any of the one or more first apertures and any of the one or more first plate actuators is greater than a height of the first plate actuators, optionally greater than a height of the first plate actuators multiplied by three, and further optionally greater than a height of the first plate actuators multiplied by five , and/or (ii) a minimum distance between any of the one or more second apertures and any of the one or more second plate actuators is greater than a height of the second plate actuators, optionally greater than a height of the second plate actuators multiplied by three, and further optionally greater than a height of the second plate actuators multiplied by five.

Clause 31. The charged particle-optical arrangement of any of the preceding clauses, wherein, when undeformed, a mid-surface of the first plate and a mid-surface of the second plate are substantially parallel.

Clause 32. The charged particle-optical arrangement of any of the preceding clauses, wherein the first plate and/or the second plate are formed from a material comprising silicon, optionally wherein the first plate and/or the second plate are formed from a material substantially comprising silicon, and further optionally wherein the first plate and/or the second plate are formed from a material consisting essentially of silicon.

Clause 33. The charged particle-optical arrangement of clause 32, wherein the silicon comprises monocrystalline silicon.

Clause 34. The charged particle-optical arrangement of any of the preceding clauses, wherein a thickness of the first plate and/or a thickness of the second plate is less than or equal to 40 $\mu$m, optionally less than or equal to 40 $\mu$m, and further optionally less than or equal to 150 $\mu$m

Clause 35. The charged particle-optical arrangement of any of the preceding clauses, further comprising one or more spacers configured to isolate the first plate from the second plate, and optionally wherein the one or more spacers are arranged to at least partially support the first plate and/or the second plate.

Clause 36. The charged particle-optical arrangement of any of the preceding clauses, wherein the charged particle-optical arrangement is an objective lens arrangement configured to project the one or more beams onto the sample.

Clause 37. The charged particle-optical arrangement of any of the preceding clauses, wherein the first plate and the second plate are electrodes.

Clause 38. The charged particle arrangement of any of the preceding clauses, wherein the charged particle arrangement is an electron-optical arrangement.

Clause 39. A lens arrangement comprising the charged particle-optical arrangement of any of the preceding clauses.

Clause 40. The lens arrangement of clause 39, wherein the lens arrangement is a lens array for example comprising one or more of the plates in which are defined a plurality of apertures..

Clause 41. A module comprising one or more components of a charged particle beam apparatus, the module comprising one or more of the charged particle-optical arrangements of any of clauses 1 to 38.

Clause 42. The module of clause 41, further comprising a spacer between adjoining plates of the one or more charged particle-optical arrangements, optionally wherein the spacer is interposed between plates of different charged particle-optical arrangements.

Clause 43. The module of clause 41 or 42, further comprising a detector, optionally wherein the detector is planar, further optionally wherein the module comprises a spacer interposed between the detector and an adjoining charged particle-optical arrangement, further optionally wherein the spacer interposed between the detector and the adjoining charged particle-optical arrangement is configured to support the detector, optionally at a periphery of the detector.

Clause 44. A charged particle beam apparatus comprising the charged particle-optical arrangement of any of clauses 1 to 38 or the module of any of clauses 41 to 43.

Clause 45. The charged particle beam apparatus of clause 44, wherein the charged particle beam apparatus is a multibeam apparatus configured to project a plurality of beams of charged particles towards the sample.

Clause 46. The charged particle beam apparatus of clause 44 or 45, further comprising a controller configured to control the actuator arrangement.

Clause 47. The charged particle beam apparatus of any of clauses 44 to 46, wherein the actuator arrangement comprises one or more piezoelectric actuators, and the controller is configured to control the force applied to the first plate and/or the second plate by the piezoelectric actuators by controlling the magnitude of a potential applied to the piezoelectric actuators, optionally wherein the magnitude of the potential applied to the piezoelectric actuators is controlled so that the force applied to the first plate and/or the second plate by the piezoelectric actuators counteracts the deformation of the first plate and/or the second plate.

Clause 48. The charged particle beam apparatus of clause 46 or 47, wherein the controller is configured to control the actuator arrangement based on the potential difference between the first plate and the second plate.

Clause 49. The charged particle beam apparatus of any of clauses 44 to 48, wherein the charged particle beam apparatus is a multibeam scanning electron microscope, optionally wherein the charged particle beam apparatus is an assessment apparatus.

Clause 50. The charged particle beam apparatus of any of clauses 44 to 49, wherein the charged particle beam apparatus comprises a plurality of sources and a plurality of charged particle devices for projecting a plurality of charged particles towards a sample, the each source corresponding to one of the charged particle devices, and wherein the apparatus comprises a different actuator arrangement for each device.

Clause 51. The charged particle beam apparatus of any of clauses 44 to 50 further comprising a power supply configured to supply a voltage to the charged particle apparatus, optionally wherein the power supply is configured to apply the respective potential difference to the first plate and second plate of the one or more charged particle-optical arrangements.

Clause 52. A method of operating an charged particle-optical apparatus for assessing a sample, the method comprising use of the charged particle beam apparatus of any of clauses 44 to 51.

Clause 53. A method of operating a charged particle arrangement of an charged particle beam apparatus for directing one or more charged particle beams towards a sample, the method comprising: applying a potential difference between a first plate and a second plate so as to apply a deforming force between the first and second plates, wherein the first plate defines at least one first aperture for passage of at least one beam therethrough and the second plate defines at least one second aperture for passage of the at least one beam therethrough; and controlling an actuator arrangement to apply an actuating force to the first plate which counteracts the deforming force applied to the first plate.

Clause 54. The method of clause 53, further comprising controlling the actuator arrangement to apply a further actuating force which counteracts the deforming force applied to the second plate.

Clause 55. The method of clause 53 or 54, further comprising directing a charged particle beam towards a sample though the first aperture and second aperture.

Clause 56. The method of any of clauses 53 to 55, wherein the applying the potential difference between the first plate and the second plate generates an electric field between the first plate and the second plate.

Clause 57. The method of any of clauses 53 to 56, further comprising operating on the beam by passage through the first and second apertures.

Clause 58. The method of clause 57, wherein the controlling of the actuator arrangement comprises adjusting deformation of the first plate and/or the second plate to adjust the operating on the beam by passage through the first and second apertures.

## Claims

1. An charged particle-optical arrangement for a charged particle beam apparatus configured to operate on at least one beam of charged particles, the charged particle-optical arrangement comprising:

   a first plate which defines at least one first aperture for passage of the at least one beam therethrough; and
   a second plate which defines at least one second aperture for passage of the at least one beam therethrough; and
an actuator arrangement configured to apply a force to the first plate.

2. The charged particle-optical arrangement of claim 1, wherein the first plate and the second plate are arranged such that, when a potential difference is applied between the first plate and the second plate, an electrostatic force is exerted on the first plate in the direction of the second plate, and the actuator arrangement is configured to apply the force to the first plate to counteract a deformation of the first plate caused by the electrostatic force applied to the first plate.

3. The charged particle-optical arrangement of claim 2, wherein the actuator arrangement is configured to apply the force to the first plate to modify the shape of the deformation of the first plate.

4. The charged particle-optical arrangement of any of claims 1 to 3, wherein the charged particle-optical arrangement is adapted to be used in a multibeam apparatus configured to operate on a plurality of beams of charged particles, optionally wherein the plurality of beams of charged particles are in a beam grid.

5. The charged particle-optical arrangement of claim 4, wherein:

the first plate defines a plurality of first apertures, wherein each one of the plurality of first apertures is for the passage of one or more of the plurality of beams through the first plate; and
the second plate defines a plurality of second apertures, wherein each one of the plurality of second apertures is for the passage of one or more of the plurality of beams through the second plate.

6. The charged particle-optical arrangement of any of claims 2 to 5, wherein the deformation of the first plate caused by the electrostatic force comprises electrostatically-induced mechanical distortion of the first plate, optionally wherein the deformation of the first plate caused by the electrostatic force comprises bowing of the first plate,.

7. The charged particle-optical arrangement of any of the preceding claims, wherein the first plate is configured to be supported at an edge portion thereof, wherein the charged particle-optical arrangement further comprises a spacer.

8. The charged particle-optical arrangement of claim 7, wherein the actuator arrangement is configured to apply the force to a peripheral portion of the first plate,.

9. The charged particle-optical arrangement of any of the preceding claims, wherein the force applied to the first plate by the actuator arrangement is a first plate force, and the actuator arrangement comprises one or more first plate actuators configured to apply the first plate force to the first plate.

10. The charged particle-optical arrangement of claim 9, wherein the one or more first plate actuators are controllable such that the magnitude of the first plate force can be varied.

11. The charged particle-optical arrangement of claim 9 or 10, wherein the one or more first plate actuators are disposed outside of an electric field between the first plate and the second plate,

12. The charged particle-optical arrangement of any of claims 9 to 11, wherein the actuator arrangement comprises a plurality of first plate actuators distributed around the peripheral portion of the first plate.

13. The charged particle-optical arrangement of any of the preceding claims, wherein the actuator arrangement comprises at least one electrical connection for each plate, the electrical connection configured to supply power to the actuator arrangement.

14. The charged particle arrangement of any of the preceding claims, wherein the charged particle arrangement is an electron-optical arrangement.

15. A method of operating a charged particle arrangement of an charged particle beam apparatus for directing one or more charged particle beams towards a sample, the method comprising:

applying a potential difference between a first plate and a second plate so as to apply a deforming force between the first and second plates, wherein the first plate defines at least one first aperture for passage of at least one beam therethrough and the second plate defines at least one second aperture for passage of the at least one beam therethrough; and
controlling an actuator arrangement to apply an actuating force to the first plate which counteracts the deforming force applied to the first plate.

# Fig. 1

# Fig. 2

# Fig. 3

# Fig. 4

EP 4 597 539 A1

# Fig. 5

## Fig. 6

100μm  50μm

341

5kV

few kV

340  5kV – 10 to 100V

308  5kV

306

## Fig. 7

340

305

304

306

## Fig. 8

310

309

304

307

305

306

# Fig. 9

# Fig. 10

# Fig. 11

# Fig. 12

# Fig. 13

## Fig. 14A

81B

81

81A

85

## Fig. 14B

81

81A

81B

85a

85b

## Fig. 14C

81A

81

81B

85a

85b

85c

# Fig. 15

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/392734 A1 (SAROV YANKO [DE] ET AL) 8 December 2022 (2022-12-08) * figs. 1, 2, 16 and related text; paragraphs [0069], [0111], [0112] * | 1-15 | INV. H01J37/12 |

-----

TECHNICAL FIELDS
SEARCHED      (IPC)

H01J

The present search report has been drawn up for all claims

| Place of search | Date of completion of the search | Examiner |
|---|---|---|
| Munich | 21 June 2024 | Krauss, Jan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

  .................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 4738

This annex lists the patent family members relating to the patent documents cited in the above-mentioned European search report.
The members are as contained in the European Patent Office EDP file on
The European Patent Office is in no way liable for these particulars which are merely given for the purpose of information.

21-06-2024

| Patent document cited in search report | Publication date | Patent family member(s) | Publication date |
|---|---|---|---|
| US 2022392734 A1 | 08-12-2022 | CN 115244645 A | 25-10-2022 |
| | | EP 4118673 A1 | 18-01-2023 |
| | | JP 2023517626 A | 26-04-2023 |
| | | KR 20220153040 A | 17-11-2022 |
| | | TW 202201454 A | 01-01-2022 |
| | | US 2022392734 A1 | 08-12-2022 |
| | | WO 2021180365 A1 | 16-09-2021 |

EPO FORM P0459

For more details about this annex : see Official Journal of the European Patent Office, No. 12/82

**REFERENCES CITED IN THE DESCRIPTION**

**Patent documents cited in the description**

- EP 2425444 A
- EP 20184161 A
- EP 20158804
- EP 20158732
- EP 23211553
- EP 23217694